# EUROPÄISCHE PATENTSCHRIFT

(11) **EP 2 573 904 B1**
(45) Veröffentlichungstag und Bekanntmachung des Hinweises auf die Patenterteilung: **05.12.2018**
(21) Anmeldenummer: 12002023.5
(22) Anmeldetag: 22.03.2012
(51) Int. Cl.: H02M 3/338, H02M 7/48, H02J 50/12, H02J 50/40

(54) **SPANNUNGSGEREGELTER OSZILLATOR FÜR GROSSSIGNALE**
LARGE SIGNAL VOLTAGE CONTROLLED OSCILLATOR
OSCILLATEUR GRAND SIGNAL COMMANDÉ EN TENSION

(30) Priorität: 04.04.2011 DE 102011016027
(43) Veröffentlichungstag der Anmeldung: 27.03.2013
(60) Teilanmeldung: 18000769.2
(73) Patentinhaber: Rehm, Markus, 78052 Villingen-Schwenningen (DE)
(72) Erfinder: Rehm, Markus, 78052 Villingen-Schwenningen (DE)

(56) Entgegenhaltungen:
- WO-A1-2006/132570
- WO-A1-2011/001168
- GB-A- 2 433 381
- GB-A- 2 467 931
- US-A- 4 438 386
- US-A1- 2003 231 039
- SEN P C ET AL: "Thyristor-Controlled Single Phase Variable Inductor", IEEE TRANSACTIONS ON MAGNETICS,, Bd. MAG-3, Nr. 3, 1. September 1967 (1967-09-01), Seiten 240-245, XP001604318,

## Beschreibung

### TECHNISCHES GEBIET DER ERFINDUNG

Die aktuelle Erfindung bezieht sich auf die Generierung von elektromagnetischen Wellen mittels Resonanznetzwerk und insbesondere auf Leistungsübertragung im Nahfeld für RFID und drahtlose Speisungen. Des Weiteren bezieht sich die aktuelle Erfindung auf die Steuerung der Resonanzfrequenz eines Oszillators mittels geschaltenem Resonanznetzwerks.

### HINTERGRUND DER ERFINDUNG

Drahtlose Energieversorgung von Geräten kann mittels induktiver- und / oder kapazitiver Nahfeldkopplung realisiert werden. Dies wird in vielen RFID Systemen und drahtlosen Batterieladegeräten eingesetzt.

Eine Quelleneinheit, im Folgenden als Basiseinheit bezeichnet, generiert ein elektromagnetisches Wechselfeld dessen Strahlungseinheit meisst als Resonanzkreis ausgebildet ist. Durch den Resonanzkreis lässt sich ein Wechselfeld mit wenig Aufwand effizient erzeugen, weil die Treiberschaltungen praktisch keine Schaltverluste generieren (Zero Voltage ZVS- oder Zero Current Switching ZCS). Die Filterwirkung des Resonanzkreises beeinflusst die spektrale Leistungsdichte und unterdrückt Oberwellen.

Ein Generator in der Basisstation treibt einen Resonanzkreis mit einem Signal, dessen Frequenz und Amplitude variert werden kann, um die zu übertragende Leistung zu steuern. Das mit Energie zu versorgende Gerät, im Folgenden als Lasteinheit bezeichnet, wird im Abstand eines Bruchteils der Wellenlänge des elektromagnetischen Wechselfeldes so plaziert, dass zwischen Basis- und Lasteinheit möglichst gute Kopplung besteht. Dazu wird auf gleiche Polarisation, minimale Distanz und auf grösste Kopplungsfläche optimiert. Oft werden auch zusätzliche weichmagnetische Materialien verwendet um die Kopplung weiter zu erhöhen und / oder den Feldverlauf zu lenken.

Es ist bekannt, dass bei der Verwendung eines Resonanzkreises in der Lasteinheit die übertragbare Leistung bei gegebener Kopplung erhöht werden kann. Optimalerweise sollte der Lastresonanzkreis genau auf die Frequenz des magnetischen Wechselfeldes abgestimmt sein, wobei man aber einen Kompromiss zwischen erzielbarer Bandreite und Kopplungsgewinn abwägt.

In "System description Wireless Power Transfer" ist ein Schwingkreis gezeigt, der von einem Generator getrieben wird. Hier wird über ein zuschaltbares Netzwerk eine Mehrzahl von Teilinduktivitäten an den Resonanzkreis zugeschaltet um die abgestrahlte Feldenergie auf die Fläche zu konzentrieren, wo Lasteinheiten positioniert sind. Weiter wird mit einem vorgeschalteten Spannungs- oder Stromregler die Speisung gesteuert.

Der generelle Nachteil von drahtlosen Speisungsprinzipien, welche Resonanzkreise in der Basis und/ oder in der Lasteinheit verwenden, ist die Resonanzfrequenzverstimmung. Dies ist aufgrund von Komponententoleranzen, Komponentenalterung, Kopplung und Lastentnahme gegeben. Diese Lastverstimmung ist insofern unerwünscht, weil die Impedanz des Resonanzkreises frequenzselektiv wirkt und eine vorgegebene Betriebsfrequenz nicht mehr mit der Resonanzfrequenz übereinstimmt. Folglich sinkt der Gesamtwirkungsgrad der Treiberschaltung und somit der Leistungsübertragung von Basis- zu Lasteinheit. Zusätzlich erhöhen sich die Verzerrungen, weil die Treiberschaltungen mehr Oberwellen erzeugen.

Die bekannte Netzwerkmessmethode misst zwar in einem Intervall die Resonanzfrequenz des Netzwerks und betreibt es anschliessend bei dieser Frequenz, hat aber keine Möglichkeit die Netzwerkfrequenz aktiv zu steuern. Dies wäre jedoch sehr wünschenswert, da in Richtlinien wie EN300330, REC7003 und ITU-RSM2123 Frequenzbereiche (z. Bsp. 119...135kHz) und deren maximale Amplitudenwerte bestimmt sind. Weiter existieren länderspezifische schmale Frequenzbereiche innerhalb eines Frequenzbandes die viel kleinere Grenzwerte verlangen.

Es ist daher wichtig, neben der Leistung auch die spektrale Position der abgestrahlten Leistung zu steuern.

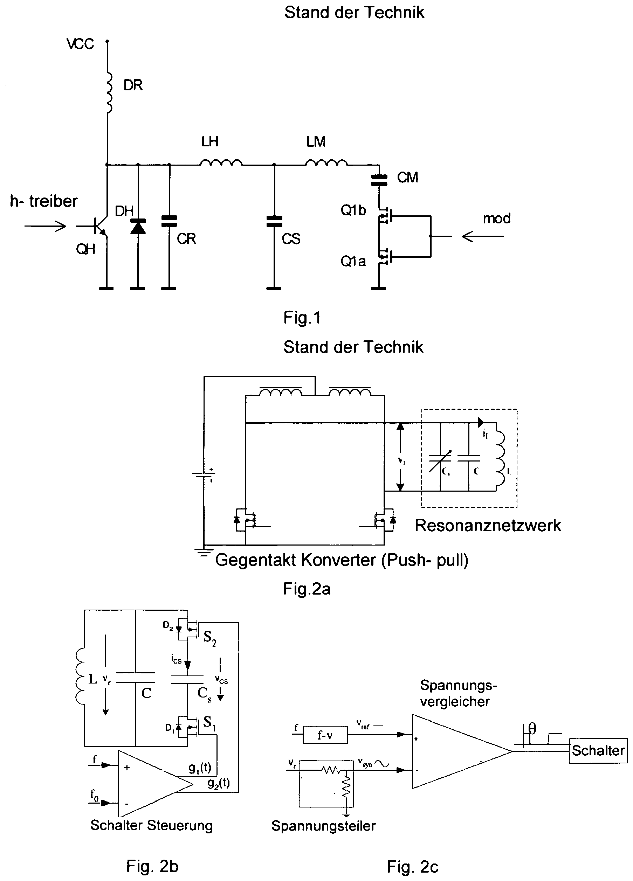

US6586895 zeigt wie man eine Induktivität oder ein Netzwerk höheren Grades mittels variablen Kopplungsintervalls während einer Teilperiode in beiden Halbwellen einer Schwingkreisperiode elektronisch steuert. Figur 1 zeigt die wesentliche Schaltung, darin bilden der Kondensator CS und die Induktivität LH einen Serienschwingkreis. Kondensator CM und die Induktivität LM werden über die gesteuerten Transistoren Q1a und Q1b und deren integrierten Dioden in zwei Teilintervallen der Schwingkreisperiode an CS gekoppelt. Die Kopplungssteuerung funktioniert in beiden Halbperioden des Schwingkreises, da der Strom in CM und LM in beiden Richtungen von der Ansteuerung der Transistoren Q1a respektive Q1b abhängig ist. Der Kondensator CR ist nicht relevant, da er über den Transistor QH und die Diode DH kurzgeschlossen bleibt; oder die Transistoren Q1a und Q1b ganz offen oder ganz geschlossen bleiben, wenn QH offen ist.

In "Stabilisation the Operating Frequency of a Resonant Converter for Wireless Power transfer to Implantable Biomedical Sensors" wird ein gesteuertes Resonanznetzwerk in einem Generator vorgeschlagen, dessen Lastresonanzkreis mittels variabler Kopplungsteuerung gesteuert werden kann (siehe Figur 2a). Dabei wird in einem LC- Schwingkreis ein zweiter Kondensator für Teilintervalle einer Schwingkreisperiode zum LC Schwingkreis gekoppelt (siehe Figur 2b). Die Schaltersteuerung vergleicht die Resonanzspannung mit einer Referenzspannung die als Steuergrösse wirkt und generiert vom Vergleicherausgangssignal das Schaltsignal für die Kopplungsschalter (siehe Figur 2c). Diese Steuerung arbeitet sehr unzuverlässig, da jede Änderung der Schwingkreisamplitude sofort die Frequenz des Schwingkreises mitbeinflusst. Amplitudenschwankungen der Resonatorspannung treten bei jeder angekoppelter Lasteinheit (bzw. deren Laständerung) auf. Zudem hat eine Amplitudensteuerung, die zur Leistungsregelung oft eingesetzt wird immer eine Frequenzverstimmung zur Folge. Die Amplitudensteuerung des Schwingkreises und dessen Frequenzsteuerung arbeiten nicht unabhängig voneinander.

Das Erzeugen von Steuersignalen, welche unabhängig sind von der zu steuernden Grösse ist sehr schwierig. Das Hauptproblem besteht darin, dass die ändernde Ausgangsgrösse sogleich die Eingangsgrösse ändert und somit das System instabil macht.

Eine weitere wichtige Anforderung an einer Basisstation, deren Frequenz gesteuert werden kann, ist die Amplitudentreue. Wird die Frequenz geändert, sollte sich die Amplitude nicht ändern. Dies ist vor allem während dem plötzlichen Umschalten (Frequenzsprüngen) schwierig, da sich die Impedanz des Resonanzkreises je nach Frequenzsprung stark ändern kann.

Wird ein Schwingkreis gebildet dessen Teilkomponenten mittels gesteuerter Teilintervallkopplung geändert werden können, ist es daher sehr wichtig, dass das Kopplungsintervall unabhängig von der Schwingkreisperiode und Schwingkreisamplituden gesteuert werden kann. Dies bedeutet die Schwingkreisfrequenz ist nur eine Funktion der Steuergrösse. Diese Unabhängigkeitsbedingung garantiert einen stabilen Betrieb unabhängig zur Güte im Resonanznetzwerk. Frequenz- oder Phasenregelschlaufen sollten möglichst kurze Fangzeiten aufweisen. Dadurch werden Frequenz- oder Phasenänderungen in Netzwerk sofort ausgeregelt. Zudem ist eine schnelle Regelschlaufe wichtig, um bei einem Sweepbetrieb einen Betriebsfrequenzbereich mit grosser zeitlicher Auflösung (kurze Verweilzeit) zu bewirtschaften.

Die nachfolgende Erfindung beschreibt ein Verfahren und deren Detailimplementationen um die Frequenz bzw. Phase eines Generators über ein frequenzgesteuertes Grossignalnetzwerk zu steuern. Das beschriebene Verfahren erfüllt alle erwähnten Anforderungen und zeichnet sich mit kurzer Fangzeit, Güte unabhängigem stabilen Betrieb und hohem Wirkungsgrad aus. Ein elektrisches Resonanznetzwerk nach dem Oberbegriff des Anspruchs 1 ist aus der US 2003/231039A1 bekannt.

Die US 2003/231039 A1 offenbart einen AC-Generator / Oszillator mit einer veränderbaren Kapazität. Der AC-Generator / Oszillator enthält einen LC-Schwingkreis, und über eine mit der Oszillatorfrequenz betätigten Schaltvorrichtung ist eine weitere Kapazität periodisch während eines Teilintervalls der resultierenden Schwingkreisperiode an den LC-Schwingkreis gekoppelt. Ein Steuereingang steuert das Teilintervall und steuert damit die Frequenz des AC-Generators / Oszillators. In einem Ausführungsbeispiel wird der Steuereingang als Stellgrösse einer Phasenregelschlaufe verwendet, um die Oszillatorfrequenz an eine Referenzfrequenz zu binden.

### KURZBESCHREIBUNG DER ZEICHNUNGEN

Figur 1 zeigt eine Schaltung zur Steuerung der Frequenz in einem Grosssignalresonanznetzwerk nach einem ersten Stand der Technik.
Figuren 2a...2c zeigen Schaltungen zur Steuerung der Frequenz in einem Grosssignalgenerator nach einem zweiten Stand der Technik.
Figur 3 zeigt das Blockschaltbild eines Grosssignal VCOs gemäss einem ersten Ausführungsbeispiel der aktuellen Erfindung.
Figur 4 zeigt ein Blockschaltbild einer gesteuerten Grosssignal Kapazität gemäss Figur 3.
Figur 5 zeigt Signale zu Figur 4.
Figur 6 zeigt das Blockschaltbild eines Grosssignal VCOs gemäss einem zweiten Ausführungsbeispiel der aktuellen Erfindung.
Figur 7 zeigt ein Blockschaltbild einer gesteuerten Grosssignal Induktivität gemäss Figur 6.
Figur 8 zeigt Signale zu Figur 7.
Figur 9 zeigt das Blockschaltbild eines Grosssignal VCOs gemäss einem dritten Ausführungsbeispiel der aktuellen Erfindung.
Figur 10 zeigt ein verfeinertes Blockschaltbildes zu Figur 9.
Figur 11 zeigt Signale zu Figur 10.
Figur 12 zeigt eine Detailschaltung eines Ausführungsbeispiels der aktuellen Erfindung.
Figur 13 zeigt eine Detailschaltung eines Ausführungsbeispiels der aktuellen Erfindung.
Figur 14 zeigt eine Detailschaltung eines Ausführungsbeispiels der aktuellen Erfindung.
Figur 15 zeigt ein Frequenzmanagement der aktuellen Erfindung.
Figur 16 zeigt ein erweitertes Frequenzmanagement der aktuellen Erfindung.

### DETAILLIERTE BESCHREIBUNG DER ERFINDUNG

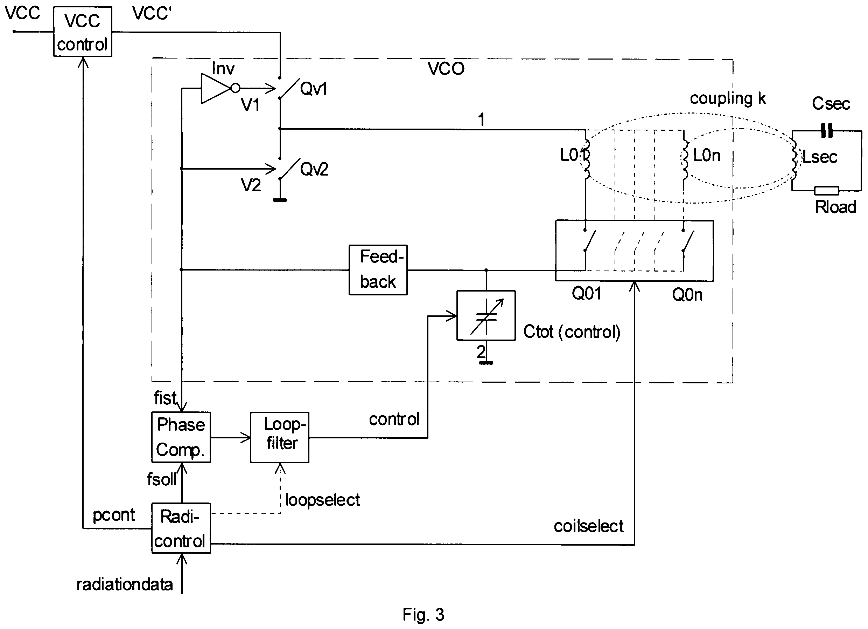

Gemäss einem ersten Ausführungsbeispiel zeigt Figur 3 das Blockschaltbild eines Serie- Gegentakt Oszillators mit einer gesteuerten Kapazität im Resonanznetzwerk. Dieser Oszillator wird hier als Basiseinheit in einem drahtlosen Speisungssystem verwendet, er kann aber als beliebiger Oszillator eingesetzt werden. Die Schalter Qv1 und Qv2 bilden eine Seriegegentaktstufe (Halbbrücke), welche ihren Mittelpunkt abwechselnd entweder auf VCC' oder an ein Referenzpotenzial (Masse) schaltet. Die Schalter Qv1 und Qv2 sind immer abwechselnd offen oder geschlossen. In einem Ausführungsbeispiel handelt es sich bei den Schaltern Qv1 und Qv2 um gleiche Typen (entweder zwei P- Kanal oder zwei N- Kanal MOSFETs bzw. entweder zwei PNP oder zwei NPN IGBTs). Die gegenphasigen Ansteuersignale V1 und V2 werden durch den Inverter (Inv) garantiert. In einem weiteren Ausführungsbeispiel handelt es sich bei den Schaltern Qv1 und Qv2 um komplementärtypen (P/N Kanal MOSFETs bzw. PNP/NPN bipolar Transistoren oder IGBTs), dort ist Inv nicht implementiert. Der Schaltermittelpunkt ist mit einem Serieschwingkreis bestehend aus einer oder mehreren Induktivitäten L01... L0n und einer oder mehreren gesteuerten Kapazitäten Ctot mit einem Referenzpotential (Masse) verbunden. Mindestens eine Induktivität L01 ist aktiv im Schwingkreis vorhanden. Falls mehrere Induktivitäten verwendet sind, ist eine beliebige Anzahl davon über Schalter Q01... Q0n an den Schwingkreis gekoppelt. Dabei können in einem beliebigen Zweig Q0n, L0n zusätzliche Serieinduktivitäten und deren Schalter implementiert sein (nicht gezeigt). Diese Schalter überbrücken je nach Ansteuerung die Serieinduktivitäten. Solche erweiterte Induktivitätsanordnungen sind bei hohen VCC', höheren übertragbaren Leistungen und / oder mehreren Lasteinheiten erforderlich. Eine Lasteinheit umfasst einen Lastwiderstand (Rload), eine Abgreifinduktivität (Lsec) und oft, aber nicht zwingend einen Kondensator Csec, der eine Lasteinheit auf die Resonanzfrequenz der Basiseinheit abstimmt. Alternativ wird auch ein Parallelschwingkreis in der Lasteinheit verwendet (nicht gezeigt). Die Abstimmung in der Lasteinheit erfolgt auf Serie- bzw. Parallelresonanz, sie ist aber nicht kritisch, weil die Dämpfung von Rload die Bandbreite wesentlich erhöht. Alle oder eine beliebige Anzahl der Induktivitäten L01... L0n sind als offene Spulen implementiert und koppeln eine oder mehrere Lasteinheiten an den Resonanzkreis der Basiseinheit. Sind mehrere Induktivitäten L01... L0n verwendet, sind sie auf einer Fläche oder auf mehreren Flächen, welche in einem Winkel zueinander stehen positioniert. Ist der entsprechende Kopplungsschalter Q01... Q0n geschlossen, generiert der Strom durch die entsprechende Induktivität L01... L0n einen Induktionsvektor. So kann das Induktionsfeld auf einer Fläche bzw. einem begrenzten Raum beliebig verteilt werden. Vorteilhafterweise wird das abgestrahlte Induktionsfeld auf diese Weise auf die Positionen der Lasteinheiten konzentriert. Es werden also nur diejenigen Induktivitäten L01... L0n an das Resonanznetzwerk gekoppelt, welche Leistung an die Lasteinheiten übertragen. Falls nur eine Lasteinheit vorhanden ist, kann derren Kopplung mit der Basiseinheit durch mehrere an das Resonanznetzwerk gekoppelte Induktivitäten L01... L0n verbessert werden. Alternativ wird in einem Ausführungsbeispiel nur eine Induktivität L01, welche permanent mit dem Resonanznetzwerk verdrahtet ist, in der Leistungsübertragung verwendet. Die Anordnung kann im Nahfeld als offener Transformator betrachtet werden, dessen Kopplung (coupling k) stark mit der geometrischen Positionierung und mit dem Abstand von L01... L0n zu Lsec variert. Ein Feedback schliesst eine Rückkopplungsschlaufe vom Resonanznetzwerk zum Schaltereingang V1 bzw. V2. Bei einem Pol der Impedanz, welcher durch L01... L0n, Ctot und dem gekoppelten Anteil von Csec und Lsec gebildet wird, ergibt sich null Grad zwischen Spannung und Strom im Resonanznetzwerk. Die Schalter und der Feedback Block weisen zusammen in ihrer Übertragungsfunktion auch null Grad auf. Somit ist die Phasenbedingung erfüllt damit eine anhaltende Schwingung entstehen kann. Die Amplitudenbedingung ist ebenfalls erfüllt, weil die resultierende Dämpfung durch Rload kleiner ist als die Vestärkung der Schlaufe (Qv1, Qv2, Resonanznetzwerk und Feedback). Der Block Feedback greift ein Teilstrom vom Resonanznetzwerk ab und generiert ein Rechteck Treibersignal für V1 bzw. V2. Dieses Treibersignal wird zusätzlich abgegriffen und an eine Phaseregelschlaufe (Phase Locked Loop PLL) als fist weitergeleitet. Darin vergleicht ein Phasenvergleicher (Phase Comp.) fist mit einer Referenzfrequenz (fsoll) und filtert das resultierende Fehlersignal im Loopfilter. Das gefilterte Fehlersignal steuert damit die Kapazität des Resonanznetzwerks Ctot. Der Begriff spannungsgesteuerter Oszillator (Voltage Controlled Oszillator VCO) wird hier und im Folgenden als allgemeiner Begriff verwendet. Es wird nicht unterschieden, ob es sich um eine Stromsteuerung oder Spannungsteuerung handelt, da beides ineinander überführt werden kann. Schwingt der Oszillator nicht auf fsoll, oder verstimmt sich die Reaktanz im Oszillator, ergibt sich ein Fehlersignal am Ausgang des Phasenvergleichers (Phase Comp.). Das gefilterte Fehlersignal regelt die Kapazität Ctot solange nach, bis die Oszillatorfrequenz (fist) wieder gleich gross ist wie die Referenzfrequenz (fsoll). Dadurch werden unterschiedliche Induktivitätswerte L01... L0n, Änderungen in der Lasteinheit, Bauteilwert Veränderungen und wechselnde Kopplungsbedingungen ausgeglichen. Durch den integrierenden Anteil der PLL- Regelschlaufe wird der Restfehler immer null. Die Phasenfehler Ausregelgeschwindigkeit ist von der Ansprechzeit von Ctot und der Stabilität im PLL bestimmt. In der aktuellen Erfindung hat Ctot eine Ansprechzeit von einer halben Schwingkreisperiode. Damit kann die PLL- Schlaufe so dimensioniert werden, dass sie schnellstmöglich wieder geschlossen wird falls sie einmal ausrastet. Dies favorisiert PLL basierende Synchronisationssysteme gegenüber Softwareregelschaltungen für solche Anwendungen weil der Hardwareaufwand klein und die Einrastzeit minimal wird. Dies liegt daran, dass der PLL-Phasenvergleicher bei jeder Netzwerkperiode mindestens ein Fehlersignal generiert, welches die Ausregelung beeinflusst. Eine PLL- Einrastzeit (Schrittantwort auf einen fsoll Wechsel) von weniger als 100 Oszillatorfrequenzperioden ist mit einem 2ten Ordnung Tiefpassfilter (Loopfilter) problemlos erreichbar, sofern kein Frequenzvorteiler in der Oszillatorsignalrückführung verwendet wird. Softwarebasierende PLL-Regelschlaufen mit den gleichen Eigenschaften sind nur mit erheblich grösserem Aufwand zu realisieren, weil die Schleife innerhalb einer Oszillatorperiode sämtliche PLL- Regelschleifenberechnungen (Phasenfehlerberechnung und Tiefpassfilterung) erledigen muss.
Die Betriebsspannung VCC' wird im Block VCC control von pcont gesteuert. Damit wird die Oszillator- bzw. Resonanznetzwerk Strom / Spannungsamplitude und demzufolge die Energie des abgestrahlten Induktionsfeldes gesteuert. Coilselect steuert die Schalter Q01... Q0n und entspricht einem Selektionssignal der Induktivitäten L01... L0n, welche an das Resonanznetzwerk gekoppelt werden. Coilselect steuert damit die geometrische Induktionsfeldverteilung.
Der Block Radicontrol generiert die erforderlichen Signale pcont, coilselect, fsoll und loopselect. Das Steuersignal radiationdata beinhaltet Parameter, welche für die Generierung von pcont, coilselect, fsoll und loopselect erforderlich sind. Radiationdata enthält eine erste Datengruppe, welche für die Generierung von pcont erforderlich ist. Dies sind Daten, die pcont direkt definieren und / oder Daten, welche definieren wie sich pcont zeitlich ändern soll. So generiert Radicontrol basierend einem ersten Wert der ersten Datengruppe ein Steuersignal (pcont) für VCCcontrol, welches Pulse an VCC' generiert und dementsprechend einen Burstbetrieb im Oszillator ergibt. Weiter generiert Radicontrol basierend einem weiteren Wert der ersten Datengruppe ein Steuersignal (pcont) für VCC control, wodurch sich VCC' und dementsprechend die abgestrahlten Feldenergie kontinuierlich ändern lassen.
Radiationdata enthält eine zweite Datengruppe, welche für die Generierung von coilselect erforderlich ist. Dies sind Daten, die coilselect direkt definieren und / oder Daten welche definieren wie sich coilselect zeitlich ändern soll. Radiationdata enthält eine dritte Datengruppe, welche für die Generierung von fsoll erforderlich ist. Dies sind Daten, die fsoll direkt definieren und / oder Daten welche definieren wie sich fsoll zeitlich ändern soll. Radicontrol generiert loopselect basierend dem Signal coilselect und falls fsoll mehr als ein Schwellwert (z. Bsp.10%) ändert auch basierend fsoll. Loopselect modifiziert die PLL Schlaufenverstärkung innerhalb des Loopfilters mittels z. Bsp. Modifizieren des Ladungspumpenstromes im Ausgang des Phasenvergleichers. Ist z. Bsp. nur eine Induktivität L01 durch coilselect ausgewählt, wird im Loopfliter mittels Verkleinerung des Ladungspumpenstromes durch loopselect die Verstärkung reduziert. Sind mehrere Induktivitäten L01... L0n ausgewählt wird umgekehrt verfahren und mittels Erhöhung des Ladungspumpenstromes durch loopselect die Verstärkung erhöht. Dies hat in beiden Fällen zur Folge, dass die Gesamtverstärkung der Regelschlaufe konstant bleibt und gleichbleibende dynamische PLL Eigenschaften resultieren. In einer weiteren Ausführung der aktuellen Erfindung wird mit loopselect eine zusätzliche Kapazität zu Ctot geschaltet. Dies erweitert den Abstimmbereich des VCOs und / oder schaltet dessen Frequenzbereich um.
Durch diese 3 Datengruppen kann Radicontrol die 3 unabhängigen Übertragungsparameter: Abgestrahlte Feldenergie, die Fläche bzw. den Raum des abgestrahlten Feldes und die Frequenz des abgestrahlten Feldes unabhängig generieren. So kann z. Bsp. die abgestrahlte Feldenergie durch pcont an beliebiger spektraler Position (fsoll) und an einer beliebigen räumlichen Position gesteuert werden. Es kann mit einer einfachen Modifikation von radiationdata ein anderes Abstrahlungsbild erzeugt werden. So können z. Bsp. auf einfache Weise länderspezifisch reduzierte Feldabstrahlungswerte an beliebigen Spektalpositionen generiert werden. Dazu enthält die dritte Datengruppe von radiationdata Daten, welche Radicontrol veranlassen an entsprechenden Spektralpositionen keine Referenzfrequenz (fsoll) zu generieren. In einem Ausführungsbeispiel verändert Radicontrol die Referenzfrequenz (fsoll) kontinuierlich (Sweep) und in einem weiteren Ausführungsbeispiel stochastisch, um das Induktionsfeld Spektral zu verteilen. Dies wird unter Berücksichtigung von nicht zu benützenden Frequenzen fsoll implementiert. Vorteilhafterweise reduziert sich damit der Maximalbetrag im Frequenzspektrum und es können höhere Leistungen übertragen werden bis der maximale Grenzwert der vom Gesetzgeber definierten Richtlinien erreicht ist. Als weiterer Vorteil werden andere Benutzer des gleichen Frequenzbereiches weniger gestört und können sich dadurch den Frequenzbereich besser teilen. Weiter können sich mehrere Benutzer den Frequenzbereich auch unter einander aushandeln, so werden Störungen untereinander minimal. Der grosse Vorteil von Frequenznachlaufschaltungen mittels Phasenregelschlaufe (PLL) ist die Unabhängigkeit der Oszillatoramplitude. Darin schwingt der Oszillator immer unter seinen Idealbedingungen (Phasen- und Amplitudenbedingung). Folglich bleibt das abgestrahlte Induktionsfeld bei Frequenzwechseln unverändert konstant.

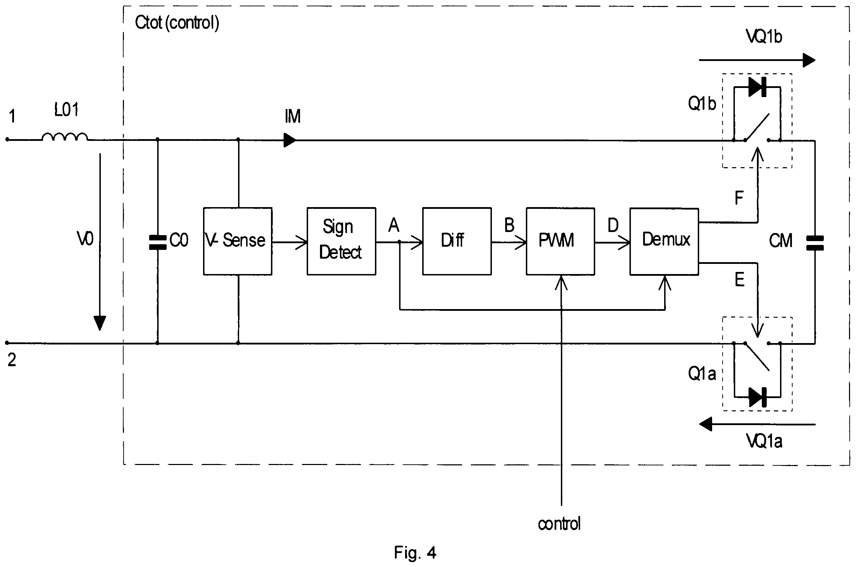

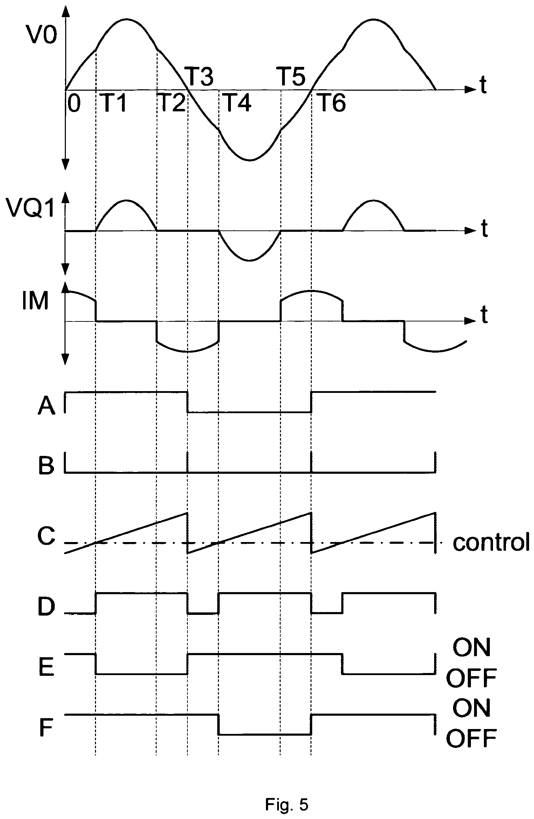

Figur 4 zeigt ein Blockschaltbild einer gesteuerten Grosssignal Kapazität (Ctot(control)) gemäss Figur 3. Signalkurvenformen zu Figur 4 sind in Figur 5 gezeigt und sind in der weiteren Beschreibung mit dessen Indizes verwendet.
Die Ankopplung an den Oszillator erfolgt über die Anschlüsse 1 und 2. Die Induktivität L01 (hier als eine von mehreren Induktivitäten L01... L0n gezeigt) und die Kapazität C0 bilden einen Serieschwingkreis. Der Kondensator CM wird über die Kopplungsschalter Q1a und Q1b an C0 gekoppelt. Die eingezeichneten Dioden deuten an, dass die Kopplungsschalter nur in eine Richtung steuerbar sind. In entgegengesetzter Stromrichtung bleiben Q1a und Q1b durch die Dioden überbrückt. In der weiteren Beschreibung definiert der Begriff Schalter funktionell den aktiv steuerbaren Teil von Q1a und Q1b. Der Begriff Kopplungschalter definiert funktionell den aktiv steuerbaren Teil und die Diode. Die erste Extremalbedingung der Schaltersteuerung stellt sich ein, wenn die Kopplungsschalter Q1a und Q1b immer offen sind. Dann ist die resultierende Gesamtkapazität gleich C0 und damit minimal. Dementsprechend ist die Schwingkreisfrequenz maximal. Die zweite Extremalbedingung der Schaltersteuerung stellt sich ein, wenn die Kopplungsschalter Q1a und Q1b immer geschlossen sind. Dann ist die resultierende Gesamtkapazität gleich der Parallelschaltung von C0 und CM und damit maximal. Dementsprechend ist die Schwingkreisfrequenz minimal. Für Teilintervallkopplung von CM mit C0 lässt sich jeder beliebige Zwischenwert der beiden Extremalwerte für die Gesamtkapazität über den Steuereingang control einstellen. Dabei bedeutet Teilintervallkopplung dass C0 und CM während eines Teiles der resultierenden Schwingkreisperiode miteinander gekoppelt sind. Dies ist in der nachfolgenden Beschreibung als Zeit- oder Winkelinterval zu verstehen. Die gesamte Schaltung repräsentiert eine Gesamtkapazität (Ctot), deren Wert von Control gesteuert wird. Die Schwingkreisfrequenz ergibt sich als Mittelwert der ganzen Schwingkreisperiode. Die momentane Schwingkreisfrequenz wechselt innerhalb der Schwingkreisperiode zwischen minimaler und maximaler bzw. maximaler und minimaler Frequenz entsprechend der Zustände der beiden Kopplungsschalter. Die resultierende Kondensatorspannung V0 wird im Block V- Sense abgegriffen und anschliessend dem Block Sign Detect zur Vorzeichenbestimmung zugeführt. Das Abgreifen der Kondensatorspannung kann auch nur eine Teilspannung umfassen, wichtig ist nur, dass das Vorzeichen des Ausgangssignals einen definierten Phasenbezug zur Spannung V0 über dem Kondensator C0 aufweist. Die daraus resultierende Kurvenform ist in A gezeigt. Der nachfolgende Differenzierer (Diff) leitet A nach der Zeit ab und gibt dessen Betrag aus, siehe Kurve B. Dies ergibt positive Pulse bei jedem Nulldurchgang 0, T3 und T6 der Schwingkreisspannung V0. Der Pulsweitenmodulator (PWM) generiert synchron zu den Pulsen von B einen Sägezahn C (in Figur 4 nicht gezeigt, da es sich um ein Signal innerhalb des PWM- Modulators handelt). Diese Sägezahnkurve C wird innerhalb des PWM Blocks mit der Steuergrösse control verglichen. Ist control kleiner als C, ist der PWM- Ausgang D hoch. Ist control grösser als C, ist der PWM- Ausgang D tief. Basierend der bekannten Pulsweitenmodulation (PWM) ist der Modulator auf verschiedene Arten zu realisieren. Wesentlich ist nur, dass das PWM Signal D von B getriggert wird und von control in seiner Pulslänge gesteuert wird. Diese Pulslänge entspricht einer gesteuerten Verzögerung, welche vom Triggermoment (Signal B) an von control gesteuert ist. Der nachfolgende Block Demux wählt unter Benutzung von Signal A einen Anteil der entsprechenden Halbwelle aus und führt ihn den Schaltern Q1a und Q1b zu. Ist A hoch, steuert das negierte Signal D über E den Schalter Q1a. Ist A tief, steuert das negierte Signal D über F den Schalter Q1b. Ist D über A mit dem entsprechenden Ausgang E bzw. F nicht verknüpft, bleibt E bzw. F hoch. Der Schalter Q1a bzw. Q1b ist geschlossen (ON) wenn E bzw. F hoch ist. Falls E bzw. F tief ist, sind Q1a bzw. Q1b offen.
Die Schalter bleiben immer mindestens für eine Halbperiode geschlossen und überbrücken ihre interne Diode. Dies resultiert in kleineren Durchlassverlusten und verhindert das Entstehen von Einschwingtransienten während dem Einschalten der Dioden. Die Dioden können immer noch einen gewissen Reststrom führen. Das Verfahren bewirkt auf jeden Fall eine Verringerung der Verluste vor allem, wenn der Durchlasswiderstand der Schalter (Rdson) genügend klein ist. Wird E tief, öffnet der Kopplungsschalter Q1a und es entwickelt sich eine positive sinusförmige Spannungshalbwelle in der Summenspannung von VQ1 = VQ1a + VQ1b während dem Zeitintervall von T1 bis T2. Während diesem Intervall fliesst kein Strom durch CM. Wird die Spannung VQ1 zu null (Zeitpunkt T2), erzwingt die gespeicherte Energie in L0 einen negativen Stromfluss in der internen Diode vom Kopplungsschalter Q1a. Dieser dauert von T2 bis T3 und wird durch den leitenden (bzw. invers leitenden) Schalter Q1a abgelöst. Die Kopplungsschalter Q1a und Q1b bleiben geschlossen bis das Signal F tief geht. Es entwickelt sich eine negative sinusförmige Spannungshalbwelle in der Summenspannung VQ1 während dem Zeitintervall von T4 bis T5. Während diesem Intervall fliesst kein Strom durch CM. Wird die Spannung VQ1 zu null (Zeitpunkt T5), erzwingt die gespeicherte Energie in L0 einen negativen Stromfluss in der internen Diode vom Kopplungschalter Q1b. Dieser dauert von T5 bis T6 und wird durch den leitenden (bzw. invers leitenden) Schalter Q1b abgelöst. Das gesamte Stromflussintervall der internen Dioden beschränkt sich auf das Intervall von T2 bis T3 und T5 bis T6. Die Kapazitäten C0 und CM in Figur 4 sind falls grössere Induktivitätswerte und / oder hohe Betriebsspannung VCC' verlangt ist als Serieschaltung ausgeführt (nicht gezeigt). In diesem Fall greift der Block V-Sense die Gesamtspannung über beiden Kapazitäten (C0 und CM) ab. Alle übrigen Blöcke und deren Verhalten bleiben unverändert. Dies gilt auch, falls zusätzliche Kapazitäten in der Serieschaltung von C0 und CM parallel zu den Schaltern Q1a und Q1b bestückt sind. Es ist weiter offensichtlich, dass sich die Funktion des Blockdiagramms in Figur 4 nicht ändert, wenn CM in zwei Teilkapazitäten zerlegt ist und die beiden Schalter Q1a und Q1b je eine Teilkapazität von CM zu C0 koppeln. Vorteilhafterweise liegen dann die beiden Schalter Q1a und Q1b parallel zueinander, was zu kleineren Durchlassverlusten führt.

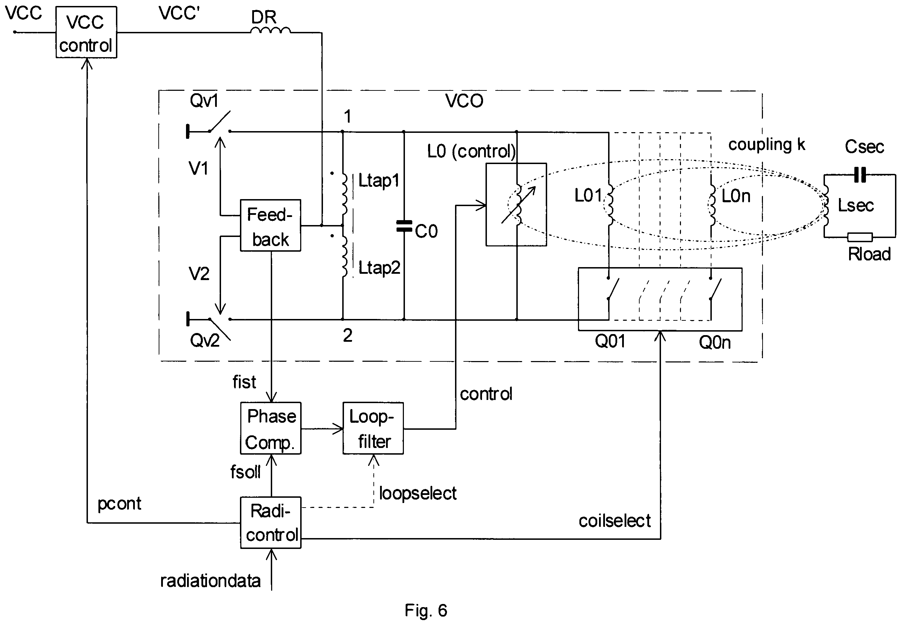

Ein Oszillator bleibt auch dann funktionsfähig, wenn anstelle einer gesteuerten Kapazität eine gesteuerte Induktivität verwendet wird um die Frequenz zu steuern. Gemäss einem weiteren Ausführungsbeispiel zeigt Figur 6 ein ParallelGegentakt Oszillator, welcher gegenüber der Halbbrücke bei gleichem Schaltungsaufwand mehr Leistung liefert. Eine symmetrisch angezapfte Spule (Ltap1 und Ltap2) wird an beiden Enden über je einen Schalter (Qv1 und Qv2) abwechselnd nach einem Referenzpotential (Masse) geschaltet. An den beiden Enden von Ltap1 und Ltap2 wird eine oder mehrere gesteuerte Induktivitäten (L0) und eine oder mehrere Zusatzinduktivitäten L01... L0n an Ltap1 und Ltap2 gekoppelt. Dies wird alternativ über zusätzliche Seriekapazitäten (nicht gezeigt) implementiert. Die Kapazität C0 bildet mit Ltap1, tap2, L0 und L01... L0n einen Parallelschwingkreis. Falls meherere Induktivitäten L01... L0n verwendet werden, können eine beliebige Anzahl davon über Schalter Q01... Q0n an den Schwingkreis gekoppelt werden. Dabei können in einem beliebigen Zweig Q0n, L0n zusätzliche Serieinduktivitäten und deren Schalter implementiert sein (nicht gezeigt). Diese Schalter überbrücken je nach Ansteuerung die Serieinduktivitäten. Solche erweiterte Induktivitätsanordnungen können bei hohen VCC', höheren übertragbaren Leistungen und / oder mehreren Lasteinheiten erforderlich sein. Eine Lasteinheit umfasst einen Lastwiderstand (Rload), eine Abgreifinduktivität (Lsec) und oft, aber nicht zwingend einen Kondensator Csec, der eine Lasteinheit auf die Resonanzfrequenz der Basiseinheit abstimmt. Alternativ wird auch ein Parallelschwingkreis in der Lasteinheit verwendet (nicht gezeigt). Die Abstimmung in der Lasteinheit erfolgt auf Serie- bzw. Parallelresonanz, sie ist aber nicht kritisch, weil die Dämpfung von Rload die Bandbreite wesentlich erhöht. Alle oder eine beliebige Anzahl der Induktivitäten Ltap1, Ltap2, L0, L01... L0n sind als offene Spulen implementiert und koppeln eine oder mehrere Lasteinheiten an den Resonanzkreis der Basiseinheit. Sind mehrere Induktivitäten Ltap1, Ltap2, L0, L01... L0n verwendet, sind sie auf einer Fläche oder auf mehreren Flächen, welche in einem Winkel zueinander stehen positioniert. Ist der entsprechende Spulenkopplungsschalter Q01... Q0n geschlossen, generiert der Strom durch die entsprechende Induktivität L01... L0n einen Induktionsvektor. So kann das Induktionsfeld auf einer Fläche bzw. einem begrenzten Raum beliebig verteilt werden. Vorteilhafterweise wird das abgestrahlte Induktionsfeld auf die Positionen der Lasteinheiten konzentriert. Es werden also nur diejenigen Induktivitäten L01... L0n an das Resonanznetzwerk gekoppelt, welche Leistung an die Lasteinheiten übertragen. Falls nur eine Lasteinheit vorhanden ist, kann deren Kopplung mit der Basiseinheit durch mehrere an das Resonanznetzwerk gekoppelte Induktivitäten L01... L0n verbessert werden. Die Anordnung kann im Nahfeld als offener Transformator betrachtet werden, dessen Kopplung (coupling k) stark mit der geometrischen Positionierung und mit dem Abstand von Ltap1, Ltap2, L0, L01...L0n zu Lsec variert. Das Feedback schliesst eine Rückkopplungsschlaufe vom Resonanznetzwerk auf den Schaltereingang von Qv1 und Qv2. Die Spule DR wickt als Filter in der Speisungsleitung und reduziert damit die harmonischen Verzerrungen der Gegentaktstufe (Qv1, Qv2). Im Wesentlichen wirkt DR als Stromquelle auf den Anzapfungspunkt und lässt so Vollweggleichrichtspannung, dessen Mittelwert gleich VCC' ist, am Anzapfungspunkt entstehen. Der Minimalwert der Spannung am Anzapfungspunkt entspricht dem Spannungsnulldurchgang der Spannung über C0. Dieser Spannungsnulldurchgang bzw. der Minimalwert der Spannung am Anzapfpunkt der Spulen Ltap1, Ltap2 triggert einen Frequenzteiler innerhalb des Blocks Feedback. Der invertierte bzw. der nichtinvertierte Ausgang des Frequenzteilers steuert Qv1 bzw. Qv2. Ist z. Bsp. Qv1 geschlossen und Qv2 offen, bildet sich am Eingang vom Feedback Block eine sinusförmige Spannungshalbwelle mit der Hälfte der Spannungsamplitude der Spannung über C0. Erreicht diese Spannung ihr Minimum wird der Frequenzteiler getriggert und die Treibersignale von Qv1 und Qv2 wechseln ihre Zustände. Qv2 ist geschlossen und Qv1 offen. Es bildet sich erneut eine sinusförmige Spannungshalbwelle mit der Hälfte der Spannungsamplitude der Spannung über C0. Erreicht diese Spannung ihr Minimum wird der Frequenzteiler getriggert und die Treibersignale von Qv1 und Qv2 wechseln erneut ihre Zustände. Eines oder beide Treibersignale von Qv1 bzw. Qv2 oder das Triggersignal des Frequenzteilers innerhalb vom Block Feedback wird als fist im Phasenvergleicher (Phase Comp.) mit einer Referenzfrequenz (fsoll) verglichen. Das Fehlersignal vom Block Phase Comp. wird anschliessend im Block Loopfilter gefiltert. Das gefilterte Fehlersignal steuert die Induktivität L0 des Resonanznetzwerks. Schwingt der Oszillator nicht auf fsoll, oder verstimmt sich die Reaktanz im Oszillator, ergibt sich ein Fehlersignal am Ausgang des Phasenvergleichers (Phase Comp.). Das gefilterte Fehlersignal regelt die Induktivität L0 solange nach, bis die Oszillatorfrequenz (fist) wieder gleich gross ist wie die Referenzfrequenz (fsoll). Dadurch werden unterschiedliche Induktivitätswerte L01... L0n, Änderungen in der Lasteinheit, Bauteilwert Veränderungen und wechselnde Kopplungsbedingungen ausgeglichen. Durch den integrierenden Anteil der PLL- Regelschlaufe wird der Restfehler immer null. Die Ausregelgeschwindigkeit wird von der Ansprechzeit von L0 und der Stabilität im PLL bestimmt. In der aktuellen Erfindung hat L0 eine Ansprechzeit von einer halben Schwingkreisperiode. Damit kann die PLL-Schlaufe so dimensioniert werden, dass sie schnellstmöglich wieder geschlossen wird falls sie einmal ausrastet.

Die Blöcke VCC control und Radicontrol sowie deren Ein- und Ausgangsignale verhalten sich identisch zu ihren gleichnamigen in Figur 3. Dies bedeutet es sind die gleichen Betriebsarten implementiert.

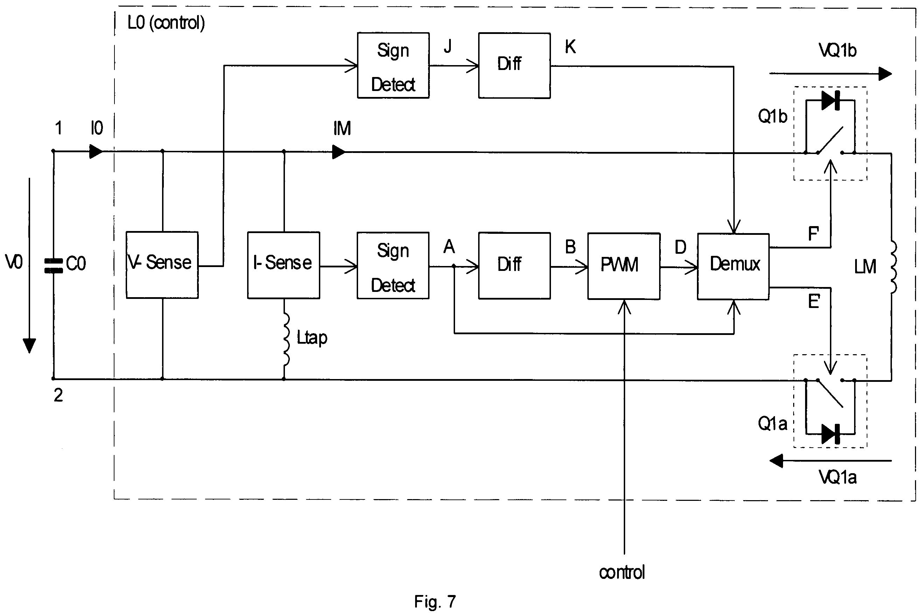

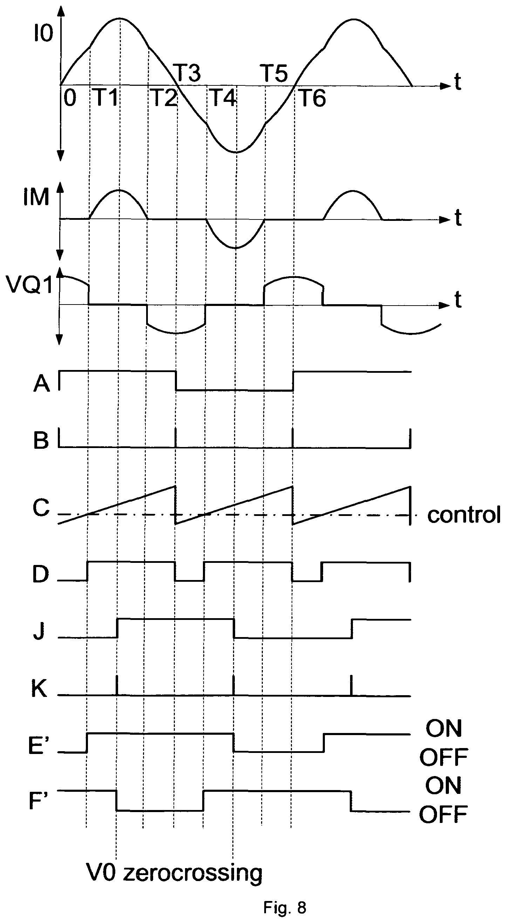

Figur 7 zeigt das Blockschaltbild einer gesteuerten Grosssignal Induktivität (L0(control)) gemäss Figur 6. Signalkurvenformen zu Figur 7 sind in Figur 8 gezeigt und sind in der weiteren Beschreibung mit dessen Indizes verwendet. Die Ankopplung an den Oszillator erfolgt über die Anschlüsse 1 und 2.
Zur einfacheren Betrachtung ist die resultierende Gesamtinduktivität Ltap (aus Ltap1 und Ltap2) in Figur 7 dargestellt. Sie bildet zusammen mit der Kapazität C0 einen Parallelschwingkreis. Die Induktivität LM wird über die Kopplungsschalter Q1a und Q1b an Ltap gekoppelt. Die erste Extremalbedingung der Schaltersteuerung stellt sich ein, wenn beide Kopplungsschalter Q1a und Q1b immer offen sind. Dann ist die resultierende Gesamtinduktivität gleich Ltap und damit maximal. Dementsprechend ist die Schwingkreisfrequenz minimal. Die zweite Extremalbedingung der Schaltersteuerung stellt sich ein, wenn beide Kopplungsschalter Q1a und Q1b immer geschlossen sind. Dann ist die resultierende Gesamtinduktivität gleich der Parallelschaltung von Ltap und LM und damit minimal. Dementsprechend ist die Schwingkreisfrequenz maximal. Für Teilintervallkopplung von LM mit Ltap lässt sich jeder beliebige Zwischenwert der beiden Extremalwerte für die Gesamtinduktivität über den Steuereingang control einstellen. Die gesamte Schaltung repräsentiert eine Gesamtinduktivität (L0), deren Wert von control gesteuert wird. Die Schwingkreisfrequenz ergibt sich als Mittelwert der ganzen Schwingkreisperiode. Die momentane Schwingkreisfrequenz wechselt innerhalb der Schwingkreisperiode zwischen minimaler und maximaler bzw. maximaler und minimaler Frequenz entsprechend der Zustände der beiden Kopplungsschalter. Der resultierende Spulenstrom wird im Block I- Sense abgegriffen und anschliessend dem Block Sign Detect zur Vorzeichenbestimmung zugeführt. Das Abgreifen des Spulenstroms kann auch nur einen Teilstrom von I0 umfassen, wichtig ist nur, dass das Vorzeichen des Ausgangssignals einen definierten Phasenbezug zum Strom I0 in der Spule Ltap aufweist. Die daraus resultierende Kurvenform ist in A gezeigt. Der nachfolgende Differenzierer (Diff) leitet A nach der Zeit ab und gibt dessen Betrag aus, siehe Kurve B. Dies ergibt positive Pulse bei jedem Nulldurchgang 0, T3 und T6 des Schwingkreisstromes I0. Der Pulsweitenmodulator (PWM) generiert synchron zu den Pulsen von B einen Sägezahn C (in Figur 7 nicht gezeigt, da es sich um ein Signal innerhalb des PWM- Modulators handelt). Diese Sägezahnkurve C wird innerhalb des PWM Blocks mit der Steuergrösse control verglichen. Ist control kleiner als C, ist der PWM- Ausgang D hoch. Ist control grösser als C, ist der PWM- Ausgang D tief. Basierend der bekannten Pulsweitenmodulation (PWM) ist der Modulator auf verschiedene Arten zu realisieren. Wesentlich ist nur, dass das PWM Ausgangssignal D von B getriggert wird und von control in seiner Pulslänge gesteuert wird. Diese Pulslänge entspricht einer gesteuerten Verzögerung, welche vom Triggermoment (Signal B) an von control gesteuert ist.
Der Block V- Sense greift die Spannung über Ltap ab und der Block Sign Detect detektiert das Vorzeichen dieser Spannung, siehe Signal J. Der nachfolgende Differentiator (Diff) leitet J nach der Zeit ab und gibt dessen Betrag aus, siehe Kurve K. Dies ergibt positive Pulse bei jedem Nulldurchgang der Schwingkreisspannung V0 (siehe V0 zerocrossing in Fig.8). Die Pulse von Signal K fallen zeitlich mit den Maxima bzw. Minima des Stromes I0 zusammen. Das Signal K wird mit A und D im Demux verknüpft, um die Treibersignale E' und F' der Schalter Q1a und Q1b zu generieren. Der Schalter Q1a bzw. Q1b ist geschlossen (ON), wenn E' bzw. F' hoch ist. Falls E' bzw. F' tief ist, ist Q1a bzw. Q1b offen. Ist A hoch, steuert das Signal D über E' das Schliessen von Schalter Q1a (siehe Zeitpunkt T1). Ist A tief, steuert das Signal D über F' das Schliessen von Schalter Q1b (siehe Zeitpunkt T4). Den Übergang von hoch (ON) zu tief (OFF) in E' und F' steuert Signal K mit A, siehe Zeitpunkte V0 zerocrossing in E' und F'. Das Signal A selektiert dabei welcher Schalter gesteuert wird. Ist A tief, öffnet Schalter Q1a über E' mit K. Ist A hoch, öffnet Schalter Q1b über F' mit K. Die Schalter bleiben immer mindestens für eine Halbperiode geschlossen und überbrücken ihre interne Diode. Das bewirkt kleinere Durchlassverluste und verhindert das Entstehen von Einschwingtransienten während dem Einschalten der Dioden. Die Dioden können immer noch einen gewissen Reststrom führen. Das Verfahren bewirkt auf jeden Fall eine Verringerung der Verluste vor allem, wenn der Durchlasswiderstand der Schalter (Rdson) genügend klein ist. Wird E' hoch, schliesst der Kopplungsschalter Q1a und es entwickelt sich eine sinusförmige Stromhalbwelle in IM. Während diesem Intervall ist die gesamte Kopplungsschalterspannung VQ1 = VQ1a + VQ1b gleich null, da beide Kopplungsschalter geschlossen sind. Wird der Strom IM im Zeitpunkt T2 wieder null, erzwingt die gespeicherte Energie in C0 einen negativen Spannungssprung in der internen Diode von Q1b und folge dessen eine Unterbrechung des Stromflusses. Wird F' hoch, schliesst der Kopplungsschalter Q1b und es entwickelt sich eine negative sinusförmige Stromhalbwelle in IM während dem Zeitintervall von T4 bis T5. Während diesem Intervall ist die gesamte Kopplungsschalterspannung VQ1 gleich null, da beide Kopplungsschalter geschlossen sind. Wird der Strom IM im Zeitpunkt T5 wieder null, erzwingt die gespeicherte Energie in C0 einen negativen Spannungssprung in der internen Diode von Q1a und folge dessen eine Unterbrechung des Stromflusses. Das Stromflussintervall der internen Dioden beschränkt sich auf das Intervall von V0 zerocrossing bis T2 der positiven Stromhalbwelle in IM bzw. T5 der negativen Stromhalbwelle in IM.
In einem weiteren Ausführungsbeispiel von Figur 6 kann L0(control) in zwei oder mehrere parallel gesteuerte Induktivitäten aufgeteilt werden. Darin sind pro Teilinduktivität L0(control) entweder je ein oder zwei Schalter (Q1a und / oder Q1b) vorhanden. Ist pro Teilinduktivität L0(control) nur ein Schalter implementiert, so ist in der zweiten Teilinduktivität auch nur ein Schalter implementiert und zwar so, dass sich in diesem Induktivitätenpaar der Summenstrom gemäss des Signals IM von Figur 8 ergibt. So wird vorteilhafterweise die Symmetrie beibehalten und der Oberwellenanteil im Oszillator und im abgestrahlten Induktionsfeld minimal gehalten.

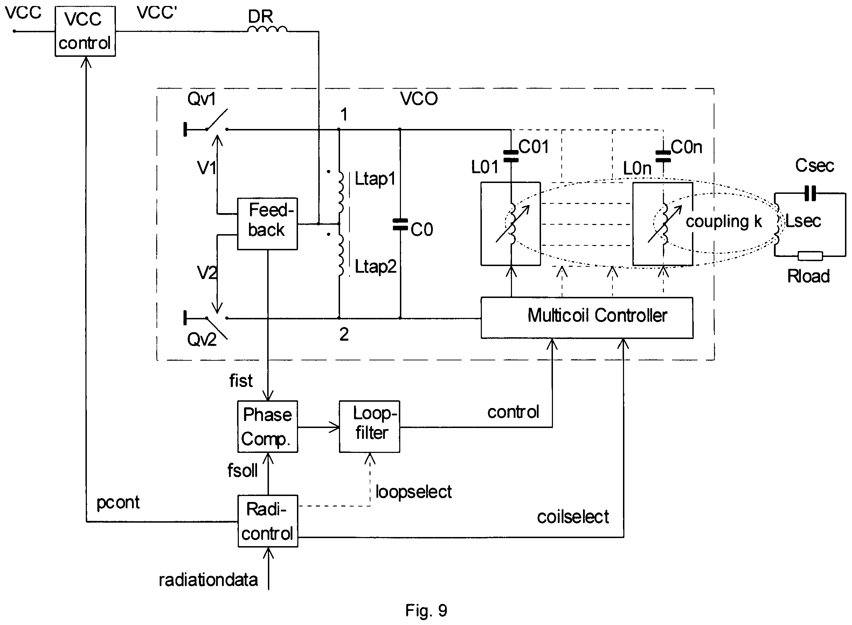

Ein Oszillator bleibt auch dann funktionsfähig, wenn im Resonanznetzwerk zusätzlich ein gesteuerter Resonanzkreis verwendet wird um die Frequenz zu steuern. Gemäss einem weiteren Ausführungsbeispiel zeigt Figur 9 einen Parallel- Gegentakt Oszillator gemäss Figur 6. Die Frequenzsteuerung umfasst hier nicht nur eine gesteuerte Induktivität sondern mindestens eine oder mehrere Serieschaltungen C01, L01... C0n, L0n, welche über Schalter an den Parallelschwingkreis (Ltap1, Ltap2 und C0) gekoppelt werden. Die Schalter sind hier im Block Multicoil Controller integriert und sie werden zur Frequenz- und Induktionsfeldsteuerung verwendet. Die entsprechenden Eingangssignale sind der Ausgang des Loopfilters (control) und coilselect vom Block Radicontrol. Das gefilterte Fehlersignal (control) steuert eine oder mehrere Serieschaltungen C01, L01... C0n, L0n des Resonanznetzwerks. Schwingt der Oszillator nicht auf fsoll, oder verstimmt sich die Admittanz im Oszillator, ergibt sich ein Fehlersignal am Ausgang des Phasenvergleichers (Phase Comp.). Das gefilterte Fehlersignals (control) regelt eine oder mehrere Serieschaltungen C01, L01... C0n, L0n solange nach, bis die Oszillatorfrequenz (fist) wieder gleich gross ist wie die Referenzfrequenz (fsoll). Dadurch werden unterschiedliche Induktivitätswerte L01... L0n, Änderungen in der Lasteinheit, Bauteilwert Veränderungen und wechselnde Kopplungsbedingungen ausgeglichen. Durch den integrierenden Anteil der PLL- Regelschlaufe wird der Restfehler immer null. Die Ausregelgeschwindigkeit wird von der Ansprechzeit der Serieschaltungen C01, L01... C0n, L0n und der Stabilität im PLL bestimmt. In der aktuellen Erfindung hat die Serieschaltungen C01, L01... C0n, L0n eine Ansprechzeit von einer halben Schwingkreisperiode. Damit kann die PLL- Schlaufe so dimensioniert werden, dass sie schnellstmöglich wieder geschlossen wird falls sie einmal ausrastet.
Die Blöcke VCC control und Radicontrol sowie deren Ein- und Ausgangsignale verhalten sich identisch zu ihren gleichnamigen in Figur 3. Dies bedeutet es sind die gleichen Betriebsarten implementiert.
Zur Energieübertragung tragen alle zum Oszillator gekoppelten Induktivitäten (L01...L0n) und alternativ auch Ltap1, Ltap2 bei. Der Oszillator ist funktionell mit Figur 6 identisch. Die Beschreibung aller Ausführungen der zum Parallelschwingkreis (Ltap1, Ltap2 und C0) gekoppelten Induktivitäten von Figur 6 sind ohne Einschränkungen auch gültig für Figur 9. Funktionell verhält sich die Frequenzsteuerung der Resonanzkreise C01, L01... C0n, L0n wie eine Induktivitätssteuerung gemäss Figur 6.

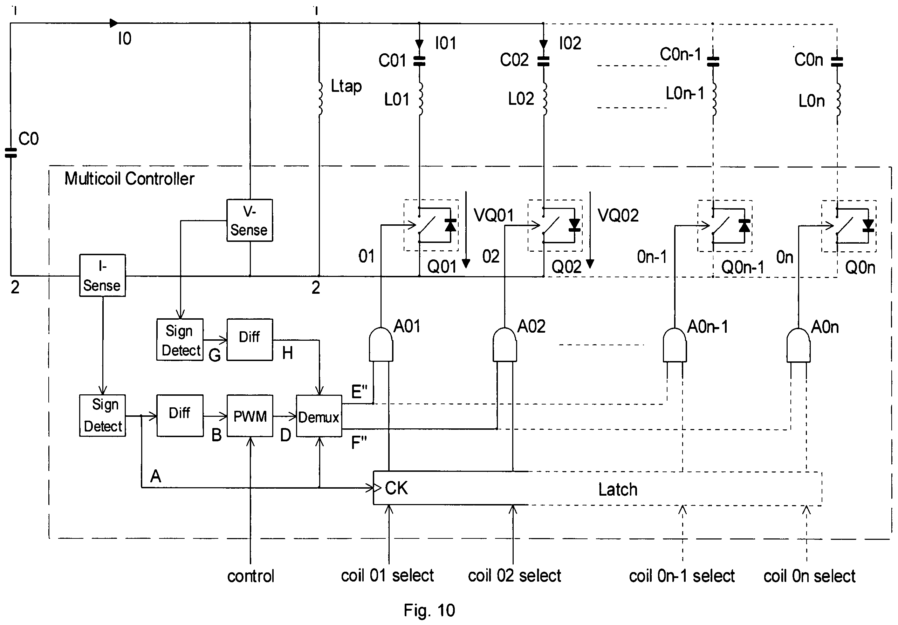

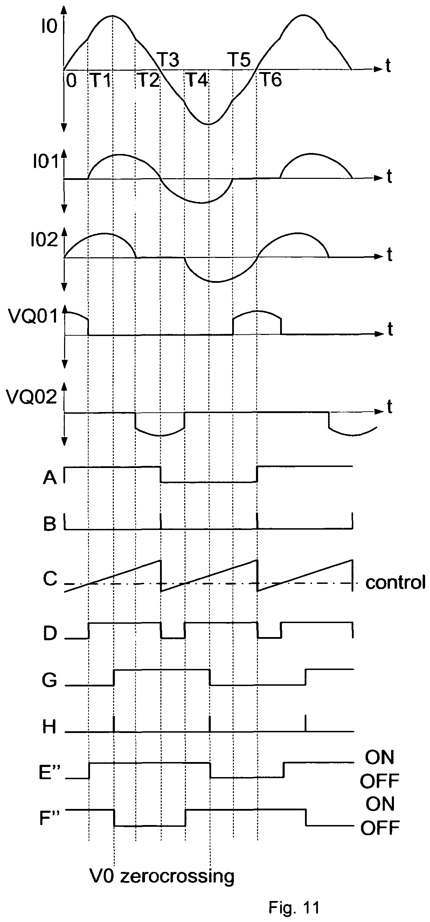

Die Kopplungsschaltersteuerung des Resonanznetzwerks gemäss Figur 9 ist in Figur 10 gezeigt. Die entsprechenden Signale sind in Figur 11 dargestellt und werden in der weiteren Beschreibung mit ihren Indizes verwendet. Die Ankopplung an den Oszillator erfolgt über die Anschlüsse 1 und 2. Zur einfacheren Betrachtung ist die resultierende Gesamtinduktivität Ltap (aus Ltap1 und Ltap2) in Figur 10 dargestellt. Sie bildet zusammen mit der Kapazität C0 einen Parallelschwingkreis. Eine oder mehrere Serieschaltungen C01, L01... C0n, L0n werden über einen oder mehrere Kopplungsschalter Q01... Q0n an Ltap gekoppelt. Die erste Extremalbedingung der Schaltersteuerung stellt sich ein, wenn alle Kopplungsschalter Q01... Q01n immer offen sind. Dann ist die resultierende Gesamtinduktivität gleich Ltap und damit maximal. Dementsprechend ist die Schwingkreisfrequenz minimal. Die zweite Extremalbedingung der Schaltersteuerung stellt sich ein, wenn alle Kopplungsschalter Q01 und Q01n immer geschlossen sind. Dann ist die resultierende Gesamtinduktivität minimal und gleich der Parallelschaltung von Ltap und der resultierenden Induktivität aller Serieschaltungen C01, L01... C0n, L0n. Dementsprechend ist die Schwingkreisfrequenz maximal. Die Serieschaltungen C01, L01... C0n, L0n sind so dimensioniert, dass ihre Serieresonanz für andauernd geschlossene Schalter Q01... Q01n tiefer liegt als die tiefste Netzwerkfrequenz bzw. tiefste Oszillatorfrequenz. Für diesen Fall wirken die Serieschaltungen als Induktivitäten und dadurch lässt sich die Gesamtinduktivität des Gesamtnetzwerks steuern. Für Teilintervallkopplung von C01, L01... C0n, L0n mit Ltap lässt sich jeder beliebige Zwischenwert der beiden Extremalwerte für die Gesamtinduktivität über den Steuereingang control einstellen. Die Schwingkreisfrequenz ergibt sich als Mittelwert der ganzen Schwingkreisperiode. Die momentane Schwingkreisfrequenz wechselt innerhalb der Schwingkreisperiode entsprechend der Zustände der Kopplungsschalter. Der resultierende Spulenstrom wird im Block I- Sense abgegriffen und anschliessend dem Block Sign Detect zur Vorzeichenbestimmung zugeführt. Das Abgreifen des Spulenstroms kann auch nur einen Teilstrom von I0 umfassen, wichtig ist nur, dass das Vorzeichen des Ausgangssignals einen definierten Phasenbezug zum Strom I0 in der Spule Ltap aufweist. Die daraus resultierende Kurvenform ist in A gezeigt. Der nachfolgende Differenzierer (Diff) leitet A nach der Zeit ab und gibt dessen Betrag aus, siehe Kurve B. Dies ergibt positive Pulse bei jedem Nulldurchgang 0, T3 und T6 des Schwingkreisstromes I0. Der Pulsweitenmodulator (PWM) generiert synchron zu den Pulsen von B einen Sägezahn C (in Figur 10 nicht gezeigt, da es sich um ein Signal innerhalb des PWM- Modulators handelt). Diese Sägezahnkurve C wird innerhalb des PWM Blocks mit der Steuergrösse control verglichen. Ist control kleiner als C, ist der PWM- Ausgang D hoch. Ist control grösser als C, ist der PWM- Ausgang D tief. Basierend der bekannten Pulsweitenmodulation (PWM) ist der Modulator auf verschiedene Arten zu realisieren. Wesentlich ist nur, dass das PWM Ausgangssignal D von B getriggert wird und von control in seiner Pulslänge gesteuert wird. Diese Pulslänge entspricht einer gesteuerten Verzögerung, welche vom Triggermoment (Signal B) an von control gesteuert ist.
Der Block V- Sense greift die Spannung über Ltap ab und der Block Sign Detect detektiert das Vorzeichen dieser Spannung, siehe Signal G. Der nachfolgende Differentiator (Diff) leitet G nach der Zeit ab und gibt dessen Betrag aus, siehe Kurve H. Dies ergibt positive Pulse bei jedem Nulldurchgang der Schwingkreisspannung V0 (siehe V0 zerocrossing in Fig.11). Die Pulse von Signal H fallen zeitlich mit den Maxima bzw. Minima des Stromes I0 zusammen. Das Signal H wird mit A und D im Demux verknüpft, um die Treibersignale E" und F" für die Schalter Q01... Q0n zu generieren. Die Treibersignale E" und F" werden über die AND Gates A01... A0n an die entsprechenden Kopplungsschalter gekoppelt. E" ist identisch zu 01, 03... 0n-1 und F" ist identisch mit 02, 04... 0n, falls coilselect alle ANDs A01... A0n auf E" und F" freigibt. Die entsprechenden Selektionssignale coil 01 select... coil 0n select werden mittels Signal A an die entsprechenden Eingänge der ANDs gekoppelt. Auf diese Weise können coil 01 select... coil 0n select zu beliebigen Zeitpunkten ändern. Es stellt sich immer ein stabiles Treibersignal 01... 0n zu jeder Netzwerkperiode ein. Die Schalter Q01... Q0n sind geschlossen (ON), wenn E" bzw. F" hoch ist. Falls E" bzw. F" tief ist, sind Q01... Q0n offen. Ist A hoch, steuert das Signal D über E" das Schliessen von Schalter Q01 (siehe Zeitpunkt T1). Ist A tief, steuert das Signal D über F" das Schliessen von Schalter Q02 (siehe Zeitpunkt T4). Den Übergang von hoch (ON) zu tief (OFF) in E" und F" steuert Signal H mit A, siehe Zeitpunkte V0 zerocrossing in E" und F". Das Signal A selektiert dabei welcher Schalter gesteuert wird. Ist A tief, öffnet Schalter Q01 über E" mit H. Ist A hoch, öffnet Schalter Q02 über F" mit H. Die Schalter bleiben immer mindestens für eine Halbperiode geschlossen und überbrücken dabei mindestens teilweise ihre internen Dioden. Das bewirkt kleinere Durchlassverluste und verhindert das Entstehen von Einschwingtransienten während dem Einschalten der Dioden. Die Dioden können immer noch einen gewissen Reststrom führen. Das Verfahren bewirkt auf jeden Fall eine Verringerung der Verluste vor allem, wenn der Durchlasswiderstand der Schalter (Rdson) genügend klein ist. Wird E" hoch, schliesst der Kopplungsschalter Q01 und es entwickelt sich ein Stromwelle in I01. Diese Stromwelle definiert eine Koppelperiode welche doppelt so lang ist wie das Intervall von T1 bis T3. Während dieser ganzen Koppelperiode ist die Kopplungsschalterspannung VQ01 gleich null. Zum Zeitpunkt T3 ist die gesamte Energie der Serieschaltung C01, L01 in C01 gespeichert. Weiter durchläuft der Strom I01 zum Zeitpunkt T3 den Nullpunkt und entlädt anschliessend im Intervall von T3 bis T5 die Kapazität C01 mit einem negativen Strom I01. Wird der Strom I01 im Zeitpunkt T5 wieder null, stoppt der Stromfluss I01 bis E" von neuem die Serieschaltung C01, L01 an das übrige Resonanznetzwerk koppelt. Wird F" hoch, schliesst der Kopplungsschalter Q02 und es entwickelt sich ein Stromwelle in I02. Diese Stromwelle definiert eine Koppelperiode welche doppelt so lang ist wie das Intervall von T4 bis T6. Während dieser ganzen Koppelperiode ist die Kopplungsschalterspannung VQ02 gleich null. Zum Zeitpunkt T6 ist die gesamte Energie der Serieschaltung C02, L02 in C02 gespeichert. Weiter durchläuft der Strom I01 zum Zeitpunkt T6 den Nullpunkt und entlädt anschliessend in der folgenden Koppelhalbperiode die Kapazität C02 mit einem positiven Strom I02. Diese Koppelhalbperiode ist identisch mit dem Intervall von 0 bis T2. Wird der Strom I02 im Zeitpunkt T2 wieder null, stoppt der Stromfluss I02 bis F" von neuem die Serieschaltung C02, L02 an das übrige Resonanznetzwerk koppelt. Die Resonanzfrequenz des Gesamtnetzwerks ändert sich je nach Kopplung der Serieschaltungen mit dem Gesamtnetzwerk. In den Intervallen von 0 bis T1 und von T5 bis T6, ist die Gesamtnetzwerkperiode bestimmt durch C0, Ltap, C02 und L02. In den Intervallen von T1 bis T2 und von T4 bis T5, ist die Gesamtnetwerkperiode bestimmt durch C0, Ltap, C01, L01, C02 und L02. Im Intervall von T2 bis T4 ist die Gesamtnetzwerkperiode bestimmt durch C0, Ltap, C01 und L01. Dies gilt, sofern man die Lasteinheit nicht berücksichtigt, ansonsten bestimmt bei jedem Teilintervall noch ein Teil der resultierenden Lasteinheit das Netzwerk. Durch späteres Einschalten der Kopplungsschalter verkleinert sich die Koppelperiode und die Schaltung wird weniger stark ausgesteuert. Dementsprechend weniger ändert sich die Gesamtnetwerkperiode bzw. Frequenz. Ab einer Koppelperiode die kleiner ist als eine Gesamtnetzwerkhalbperiode gibt es keine Überlappung mehr der beiden Kopplungsperioden C01, L01 und C02, L02.
Vorteilhafterweise kann so mit nur einem aktiven Element (mit nur einem Schalter) eine Induktivität (L01... L0n) mit einer symmetrischen Stromwelle angesteuert werden. Dies hat weniger Oberwellen im abgestrahlten Induktionsfeld zur Folge. Es ergeben sich besonders wenige Oberwellen wenn immer ein Paar von Serieschaltungen in Antiparallelschaltung (siehe C01, L01, Q01 und C02, L02, Q02) zusammen an das Gesamtnetzwerk gekoppelt werden. In diesem Fall kompensieren sich die Abstrahlungsfelder in den beiden Induktivitäten L01 und L02. Es ist weiter einfach festzustellen, dass bereits mit einem Schalter (Bsp. Q01) und einer Serieschaltung (Bsp. C01, L01) eine zur Nulllinie symmetrische Stromkurve ergibt. So ergeben sich bei weniger Hardwareaufwand günstigere Spektralverteilungen (weniger Oberwellen bzw. kleinere Verrzerrungen) gegenüber Figur 6.

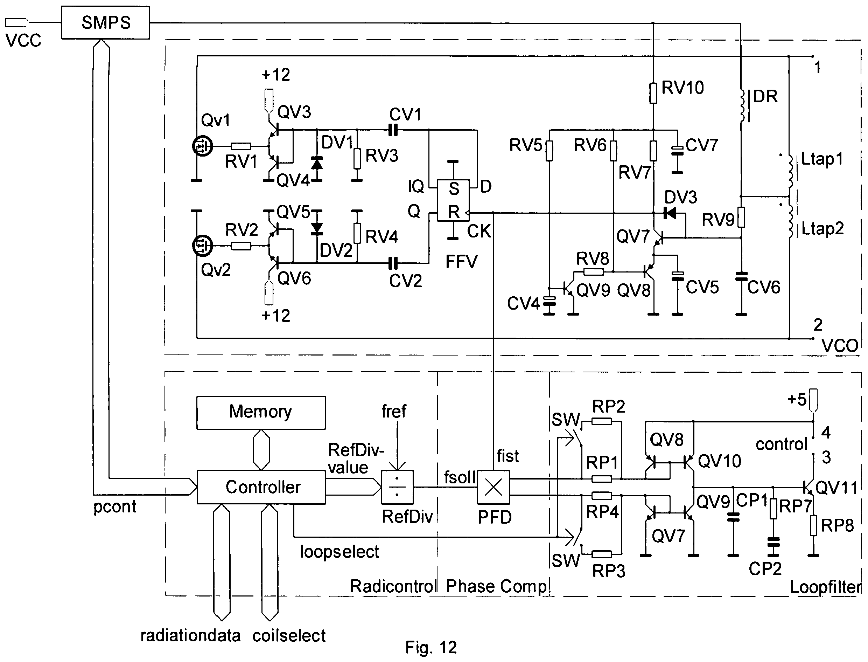

Figur 12 zeigt eine Detailschaltung eines Parallelgegentakt Grosssignal VCOs gemäss der aktuellen Erfindung. Der Oszillator entspricht im Wesentlichen demjenigen der Figuren 6 und 9. Ltap1, Ltap2 sind in einer Ausführungsvariante die Abstrahlungsspulen des Induktionsvektors (oder mindestens Teil davon). An den Enden der gekoppelten Induktivität Ltap1, Ltap2 ist je ein Schalter Qv1 und Qv2 nach Masse. Am Mittelpunkt von Ltap1, Ltap2 wird die Betriebsspannung über DR von VCC control hier als Switched Mode Power Supply (SMPS) zugeführt. An den Anschlüssen 1 und 2 wird der Resonanzkreis angeschlossen. Dies ist im einfachsten Fall eine gesteuerte Kapazität. In einem weiteren Ausführungsbeispiel sind dies gesteuerte Kapazitäten / Induktivitäten oder gesteuerte Serieschaltungen der beiden.
RV9 und CV6 bilden einen Tiefpass, der Transienten dämpft. QV7, DV3 und RV7 bilden den Spannungminimum Detektor, dessen Referenzspannung am Emitter von QV8 gefiltert mit CV5 anliegt. Die Referenzspannung wird durch den Spannungsteiler RV6 und RV8 bestimmt. QV9 ist nur für das Anschwingen zuständig und somit im Normalbetrieb über RV5 immer leitend. Durch RV10 und CV7 ist die Referenzspannung proportional zum Mittelwert der Eingangsspannung. Damit öffnet QV7 unabhängig von der Ausgangsspannung vom SMPS beim Minimum der Spannung über CV6. Die entstehenden Pulse am Kollektor QV7 triggern das Flipflop FFV. Dadurch kippen dessen Ausgänge Q und IQ. Dadurch werden die Treibertransistoren QV3... QV6 über CV1 und CV2 mit entgegengesetzen Signalen angesteuert, was die Schalterzustände von Qv1 und Qv2 wechselt. Die Kondensatoren CV1, CV2, RV3 und RV4 stellen sicher, dass bei ausbleibendem Takt am Eingang von FFV immer beide Schalter Qv1 und Qv2 offen bleiben. Dazu liegen beide Eingänge der Treiber über RV3 und RV4 immer an Masse. DV1 und DV2 klemmen die Reckteckspannungen im Normalbetrieb an Masse. Dadurch ergeben sich Treibersspannungspegel von ca. 0... 12V. Der Anlauf der Schaltung geschieht über die Zeitkonstante RV5, CV4. Die Referenzspannung über CV5 ist im ersten Moment gleich der Spannung über CV7 und dadurch ist QV7 offen. Wird QV9 leitend, sinkt die Referenzspannung über CV5 und QV7 schaltet ein. Dies generiert einen ersten Puls und daraus über FFV ein Wechsel der Treibersignale von Qv1 und Qv2. Sobald die Sinushalbwelle am Mittelpunkt von Ltap1, Ltap2 wieder minimal wird, triggert FFV erneut. Die Schalter Qv1, Qv2 wechseln ihre Zustände und der Oszillator startet. Diese digitale Ansteuerung der Schalter Qv1 und Qv2 garantiert minimalste Verluste, weil der Schalterzustandswechsel bei tiefster Schalterspannung erfolgt. Dies entspricht Zero Voltage Switching (ZVS).
Das Triggersignal von FFV wird an den Phasenvergleicher (Phase Frequency Detector PFD) als fist gekoppelt. Die Vergleichsfrequenz (fsoll) wird über einen gesteuerten Frequenzteiler (RefDiv) von einer Referenzfrequenz (fref) z. Bsp. 32MHz abgeleitet. Der PFD entspricht dem der bekannten Schaltung aus dem CMOS Baustein 4046. Im Unterschied zu 4046 werden hier die PFD-Ausgangssignale unabhängig über die Widerstände RP1... RP4 über je einen Stromspiegel QV8, QV10 bzw. QV7, QV9 an das Loopfilter CP1, CP2 und RP7 gekoppelt. Transkonduktanzverstärker QV11 generiert proportional zur Regelspannung über dem Loopfilter den Steuerstrom für die gesteuerten Admittanzen. Über RP2 und RP3 wird die PLL- Schleifenverstärkung über den Analogschalter SW umgeschaltet. Dies ändert den Ladungspumpenstrom von QV9 und QV10, welcher in das Loopfilter fliesst.

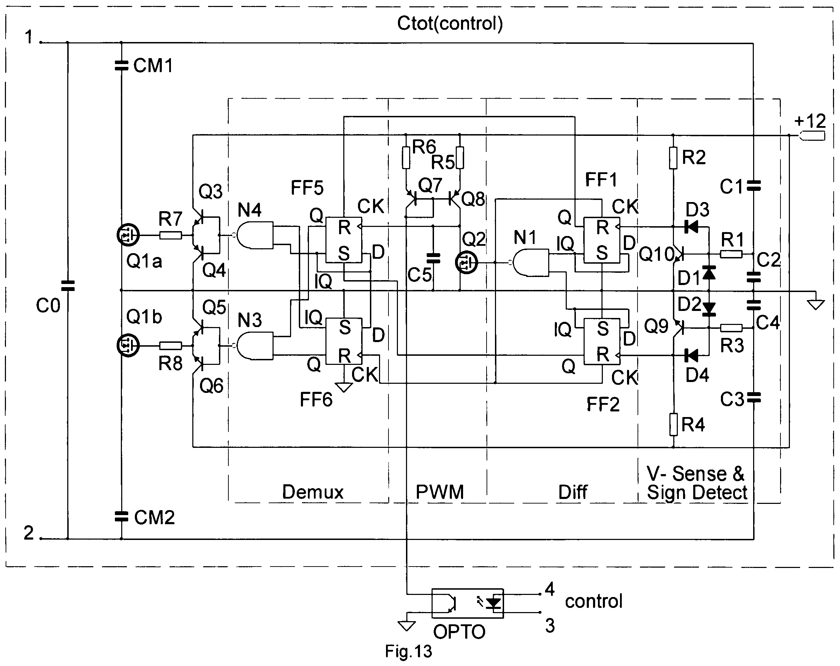

Figur 13 zeigt eine Detailschaltung einer gesteuerten Kapazität gemäss Blockschaltbild der Figur 4. Die gestrichelten Linien umfassen Teile des Blockschaltbildes. Die Ankopplung an den Oszillator erfolgt über die Anschlüsse 1 und 2. In der weiteren Beschreibung werden Kurvenformen der Figur 5 mit deren Indizes referenziert. CM ist als Serienschaltung von 2 Kondensatoren CM1 und CM2 ausgeführt, welche über Q1a und Q1b an C0 gekoppelt wird. Die Schalteransteuerung wird an einer Speisespannung +12' betrieben. Ein Optokoppler (OPTO) überträgt die Steuerinformation (control) galvanisch getrennt, da die Schaltersteuerung um +12' vom Rest des Netzwerks galvanisch getrennt ist. Die Kondensatoren C1 und C2 greifen die positive Spannungshalbwelle von V0 ab und führen sie über R1 an die Basis von Transistor Q10. Q10 agiert als quasi Spannungs- Nullpunktdetektor der positiven Halbwelle. D1 und D3 beschleunigen das Abschalten sobald die Spannung über C2 unter die Schwellenspannung von Q10 fällt. Der kapazitive Spannungsteiler C1, C2 verhindert eine Gleichspannungskopplung mit V0. Zusätzlich lässt sich über R1, C1 und C2 eine Phasenvordrehung erreichen. Zu diesem Zweck sind diese Komponenten so dimensioniert, dass die Phasenvordrehung mindestens so groß ist wie die gesamte Signalverzögerung der Steuerschaltung. Dadurch lässt sich der komplette Aussteuerbereich nutzen. Die Komponenten Q9, D2, D4, R3, R4, C3 und C4 arbeiten identisch zu den Komponenten um Q10, nur sind sie für die negative Halbwelle von V0 zuständig. Die beiden D- Flipflops FF1, FF2 und das NAND Gate N1 detektieren die beiden positiven Flanken der Ausgangssignale der Spannungs- Nullpunktdetektoren Q9 und Q10. Dazu schaltet abwechselnd ein Flipflop (FF1 bzw. FF2) am Ausgang Q auf hoch, sobald es am Clock CK getriggert wird. Dieser Zustand wird nach der Laufzeit von N1 sofort wieder über den entsprechenden Reset Eingang zurückgesetzt. So entstehen am Ausgang von N1 Spannungspulse bei jedem Nulldurchgang von V0 (Signalkurve B), welche den Transistor Q2 kurz voll durchsteuern. Diese symmetrische Implementation garantiert identisches Verhalten bezüglich der beiden Spannungshalbwellen von V0. Zudem ist Q2 nur während dem Triggermoment der kurzen Spannungspulse mit V0 gekoppelt. Q7, Q8, R6 und R5 spiegeln einen Steuerstrom, definiert durch die Steuergrösse control, welcher in den Kondensator C5 fliesst. Es ergibt sich eine Sägezahnspannung über C5 (Kurve C), die zeitlich mit den Aussteuerpulsen von Q2 ihren tiefsten Wert erreicht. Diese Sägezahnspannung triggert FF5 über den Eingang CK sobald dessen Schaltschwelle erreicht ist. Dieser Zeitpunkt ist über den Steuereingang control steuerbar, weil sich die Steilheit der Sägezahnspannung durch den Kollektorstrom in Q8 und folglich mit control ändern lässt. FF5, FF6, N3 und N4 bilden den ersten Teil vom Demux. FF5 wird über die Pulse am Set (S) bzw. Reset (R) Eingang so konfiguriert, dass der Sägezahn immer den entsprechenden Schalter ansteuert, welcher für die entsprechende Halbwelle zuständig ist. Dies entspricht der Schaltsignalselektion mittels Signalkurve A. Erscheint V0 mit der positiven Halbwelle, ist D2 leitend. Der Kollektor von Q9 ist hoch und triggert FF2 über CK. Der kurzzeitig gesetzte Ausgang Q von FF2 setzt den Ausgang Q von FF5 über dessen Set (S) Eingang. Das Tief am Ausgang IQ von FF5 erzwingt am Ausgang von N4 ein Hoch, welches Q1a über die Treiber Q3, Q4 schliesst. Dies ist die Anfangsbedingung für das gesteuerte Abkoppeln von CM1 und CM2 während der positiven Halbwelle von V0. Wird die Schaltschwelle im PWM Modulator erreicht (die Spannung über C5 ist gleich der Schaltschwelle von FF5), kippt FF5: Q ist tief und IQ hoch. IQ von FF6 ist ebenfalls auf hoch, dadurch schaltet der Ausgang von N4 auf tief, folglich öffnet der Kopplungsschalter Q1a über die Treiber Q3, Q4. Bei der negativen Halbwelle von V0 geschieht ähnliches. FF5 wird über den R Eingang von FF1 zurückgesetzt sobald D1 leitend ist und FF1 über den Clock CK getriggert wird. Dies erzwingt am Ausgang von N3 ein Hoch, welches Q1b über die Treiber Q5, Q6 schliesst. Dies ist die Anfangsbedingung für das gesteuerte Abkoppeln von CM1 und CM2 während der negativen Halbwelle von V0. Wird die Schaltschwelle im PWM Modulator erreicht (die Spannung über C5 ist gleich der Schaltschwelle von FF5), kippt FF5: Q ist hoch und IQ tief. Q von FF6 ist ebenfalls auf hoch, dadurch schaltet der Ausgang von N3 auf tief, folglich öffnet der Kopplungsschalter Q1b über die Treiber Q5, Q6. Das Schliessen der Schalter erfolgt über das Ausgangsignal von N1, welches über FF6 an CK triggert. Dadurch übernehmen die beiden Ausgänge von FF6 die Zustände von FF5. Dadurch geht N3 bzw. N4 welches vorher am Ausgang tief war auf hoch. Dadurch bleiben ab diesem Zeitpunkt immer beide Schalter Q1a und Q1b geschlossen bis der PWM Modulator einer der beiden Schalter von neuem öffnet. Das Flipflop FF6 synchronisiert sich selbst nach spätestens einer Schwingkreisperiode nach dem Einschalten der gesamten Schaltung. Dann hat immer mindestens einer der Kopplungsschalter Q1a bzw. Q1b einmal geöffnet und einen Clockpuls für FF6 generiert.

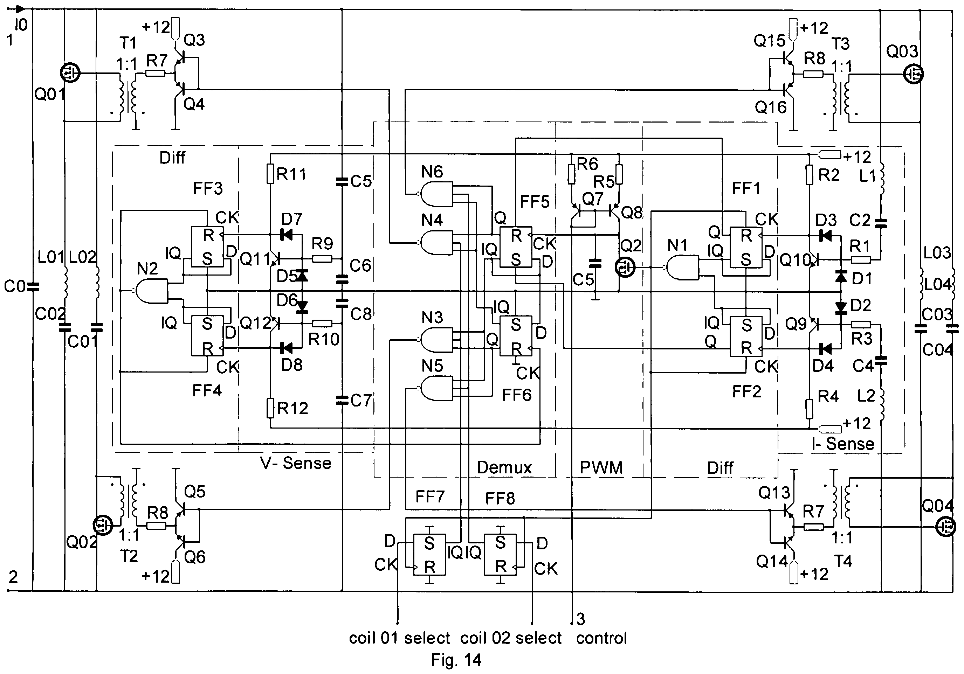

Figur 14 zeigt eine Detailschaltung einer gesteuerten Serieschaltung aus Induktivität und Kapazität gemäss Blockschaltbild der Figur 10. Die gestrichelten Linien umfassen Teile des Blockschaltbildes. Die Ankopplung an den Oszillator erfolgt über die Anschlüsse 1 und 2. In der weiteren Beschreibung werden Kurvenformen der Figur 11 mit deren Indizes referenziert. L01, C01, L02, C02, L03, C03 und L04, C04 werden über Q01... Q04 an C0 gekoppelt. Die erforderlichen Steuersignale 01... 04 der Kopplungsschalter Q01... Q04 sind von den Ausgängen der NAND Gates N3... N6 galvanisch getrennt über die Transformatoren T1... T4 an Q01... Q04 gekoppelt. Alternativ können Optokoppler mit nachfolgendem Treiber benützt werden (nicht gezeigt). Die NANDs N3... N6 bilden den Multiplexer, der die Schaltersteuerungsausgänge der Flipflops FF5 und FF6 abhängig der durch FF7 und FF8 gelatchten Selektionssignale coil 01 select und coil 02 select auswählt. Ist coil 01 select bzw. coil 02 select hoch, sind die entsprechenden NANDs (N3, N4 bzw. N5, N6) transparent und schlaufen die Ausgangssignale von FF5 und FF6 an das entsprechende Kopplungsschalterpaar (Q01, Q02 bzw. Q03, Q04) durch. In einer weiteren Ausführungsvariante sind alle 4 Eingänge der NANDs N3... N6 über 4 Steuerleitungen coil 01 select... coil 04 select selektierbar. Die Schalteransteuerung wird an einer Spannung +12 mit beliebigen Referenzpotential betrieben. Die Induktivität L1 greift die positive Stromhalbwelle von I0 ab und führt sie über R1 und C2 an die Basis von Transistor Q10. Q10 agiert als quasi Strom- Nullpunktdetektor der positiven Halbwelle. D1 und D3 beschleunigen das Abschalten sobald der Strom durch C2 sein Vorzeichen wechselt. Weiter verhindert C2 eine Gleichstromkopplung mit I0. In einem weiteren Ausführungsbeispiel ist das Stromsense Netzwerk so ausgeführt, dass sich eine Phasenvordrehung ergibt. Dadurch lässt sich der komplette Aussteuerbereich nutzen. Die Komponenten Q9, D2, D4, R3, C4 und L2 arbeiten identisch zu den Komponenten um Q10, nur sind sie für die negative Stromhalbwelle von I0 zuständig. Die beiden D- Flipflops FF1, FF2 und das NAND Gate N1 detektieren die beiden positiven Flanken der Ausgangssignale der Strom- Nullpunktdetektoren Q9 und Q10. Dazu schaltet abwechselnd ein Flipflop (FF1 bzw. FF2) am Ausgang Q auf hoch, sobald es am Clock CK getriggert wird. Dieser Zustand wird nach der Laufzeit von N1 sofort wieder über den entsprechenden Reset Eingang zurückgesetzt. So entstehen am Ausgang von N1 Spannungspulse bei jedem Nulldurchgang von I0 (Signalkurve B), welche den Transistor Q2 kurz voll durchsteuern. Diese symmetrische Implementation garantiert identisches Verhalten bezüglich der beiden Stromhalbwellen von I0. Zudem ist Q2 nur während dem Triggermoment der kurzen Spannungspulse mit I0 gekoppelt. Q7, Q8, R6 und R5 spiegeln einen Steuerstrom, welcher in den Kondensator C5 fliesst und über Anschluss 3 (control) vom Loopfilter gesteuert wird. Es entsteht eine Sägezahnspannung über C5 (Kurve C), die zeitlich mit den Aussteuerpulsen von Q2 ihren tiefsten Wert erreicht. Diese Sägezahnspannung triggert FF5 über den Eingang CK sobald dessen Schaltschwelle erreicht ist. Dieser Zeitpunkt ist über den Steuereingang control steuerbar, weil sich die Steilheit der Sägezahnspannung durch den Kollektorstrom in Q8 und folglich mit control ändern lässt. FF5, FF6, N3 und N4 bilden den Demux. FF5 wird über die Pulse am Set (S) bzw. Reset (R) Eingang so konfiguriert, dass der Sägezahn immer den entsprechenden Schalter ansteuert, welcher für die entsprechende Halbwelle zuständig ist. Dies entspricht der Schaltsignalselektion mittels Signalkurve A. Erscheint I0 mit der positiven Halbwelle, ist D2 leitend. Der Kollektor von Q9 ist hoch und triggert FF2 über CK. Der kurzzeitig gesetzte Ausgang Q von FF2 setzt den Ausgang Q von FF5 über dessen Set (S) Eingang. Das Hoch am Ausgang Q von FF5 erzwingt an den Ausgängen von N4 und N6 ein Tief, welches Q01 und Q03 über die Treiber Q3, Q4 bzw. Q15, Q16 öffnet. Dies ist die Anfangsbedingung für das gesteuerte Ankoppeln der Serieschaltungen L01, C01 und L03, C03 während der positiven Halbwelle von I0. Wird die Schaltschwelle im PWM Modulator erreicht (die Spannung über C5 ist gleich der Schaltschwelle von FF5), kippt FF5 und dessen Ausgang Q wird tief. Da IQ von FF6 unverändert hoch ist, schalten die Ausgänge von N4 und N6 auf hoch, folglich schliessen die Kopplungsschalter Q01 und Q03 über die Treiber Q3, Q4 bzw. Q15, Q16 falls coil 01 select und coil 02 select hoch sind. Bei der negativen Halbwelle von I0 geschieht ähnliches. Der invertierte Ausgang IQ von FF5 wird über den Reset (R) Eingang von FF1 gesetzt sobald D1 leitend ist und FF1 über den Clock (CK) getriggert wird. Dies erzwingt an den Ausgängen von N3 und N5 ein Tief, welches Q02 und Q04 über die Treiber Q5, Q6 bzw. Q13, Q14 öffnet. Dies ist die Anfangsbedingung für das gesteuerte Ankoppeln der Serieschaltungen L02, C02 und L04, C04 während der negativen Halbwelle von I0. Wird die Schaltschwelle im PWM Modulator erreicht (die Spannung über C5 ist gleich der Schaltschwelle von FF5) kippt FF5 und dessen invertierter Ausgang IQ wird tief. Da Q von FF6 unverändert hoch ist, schalten die Ausgänge von N3 und N5 auf hoch, folglich schliessen die Kopplungsschalter Q02 und Q04 über die Treiber Q5, Q6 bzw. Q13, Q14 falls coil 01 select und coil 02 select hoch sind. Das Öffnen der Schalter wird von Vsense und Diff gesteuert. Hierzu wird der Nulldurchgang der Spannung V0 mit einem Spannungs-Nullpunktdetektor von Figur 13 detektiert. Die Blöcke V- Sense und Diff mit all ihren Komponenten sind identisch in den Figuren 13 und 14 und sind deshalb nicht mehr näher erläutert. Die Pulse H am Ausgang von N2 signalisieren den Moment an dem die entsprechenden Schalter wieder öffnen sollen. Dieser "Ausschaltbefehl" triggert FF6 am Clock Eingang. Dadurch übernehmen die beiden Ausgänge von FF6 die Zustände von FF5. Für die positive Stromhalbwelle von I0 bleiben N4 und N6 auf hoch, N3 und N5 hingegen gehen auf tief. Für die negative Stromhalbwelle von I0 bleiben N3 und N5 auf hoch, N4 und N6 hingegen gehen auf tief. Dadurch bleibt ab diesem Zeitpunkt (V0 Zerocrossing) immer nur noch einer der Schalter Q01, Q02 bzw. Q03, Q04 der entsprechenden Halbwelle von I0 geschlossen. Dadurch wird das Abkoppeln der Serieschaltungen L01, C01... L04, C04 nur von den integrierten Dioden in Q01... Q04 bestimmt. Eine Phasenvoreilung im Block V- Sense ist nicht mehr unbedingt notwendig. Die wichtige Grenzbedingung, dass die Schalter Q01... Q04 spätestens mit der internen Dioden öffnen bleibt erfüllt. Die Flipflops N7 und N8 übernehmen bei jedem PWM- Triggerpuls (Ausgang von N1) den invertierten Zustand von coil 01 select bzw. coil 02 select. Dadurch lässt sich die Serieschwingkreisanzahl L01, C01... L04, C04 beliebig mit einer zeitlichen Auflösung von einer halben Netzwerkperiode ändern.

Der Vorteil der Differenzierung (Flankendetektierung mittels Flipflops) ist die Robustheit gegenüber Transienten, welche erst ab einem Vorzeichenwechsel der Gesamtspannung (V0) die Funktion störend beeinträchtigen. Dies macht den "Ausschaltbefehl" der Schalter Q01... Q04 unempfindlich gegenüber Transienten des Resonanzkreises. Das Flipflop FF6 synchronisiert sich selbst, spätestens eine Schwingkreisperiode nach dem Einschalten der gesamten Schaltung.
In einem weiteren Ausführungsbeispiel der Erfindung sind die Kapazitäten C01... C04 nicht bestückt und durch Brücken ersetzt in Figur 14. Dann entspricht der VCO der Ausführung gemäss Figuren 7 und 8 mit mehreren Induktivitäten.

Der Controller in Figur 12 generiert pcont, coilselect (enthaltend die Signale coil 01 select und coil 02 select) und fsoll gemäss Eingangsdaten, welche in radiationdata enthalten sind. Loopselect wird von den Daten coilselect generiert. In einem weiteren Ausführungsbeispiel wird loopselect basierend den Daten coilselect und RefDivvalue generiert. RefDivvalue teilt fref und generiert so fsoll. In einem Ausführungsbeispiel ist RefDivvalue zeitlich unverändert und generiert eine diskrete VCO Spektrallinie (gemessen nach EN300330). Diese Spektrallinie wird vom Controller über Refdivvalue und fsoll gemäss Daten innerhalb radicontrol gesteuert. Fsoll ist darin während einem Energieübertragungsintervall konstant. Ein Energieübertragungsintervall ist ein zeitlich begrenzter Abschnitt, welcher durch einen Induktionsvektor (gemessener Strom in einer Abstrahlungsspule) charakterisiert ist, der grösser als 1... 10% seines maximal möglichen Wertes ist.
In einem weiteren Ausführungsbeispiel verändert sich RefDivvalue zeitlich und verteilt einen Induktionsvektor (gemessener Strom in einer Abstrahlungsspule) auf mindestens zwei spektrale Positionen.
In einem weiteren Ausführungsbeispiel verändert sich RefDivvalue bzw. fsoll so schnell, dass sich ein Induktionsvektor (gemessener Strom in einer Abstrahlungsspule) auf mehrere Spektrallinien oder ein Spektralbereich verteilt (gemessen nach EN300330).

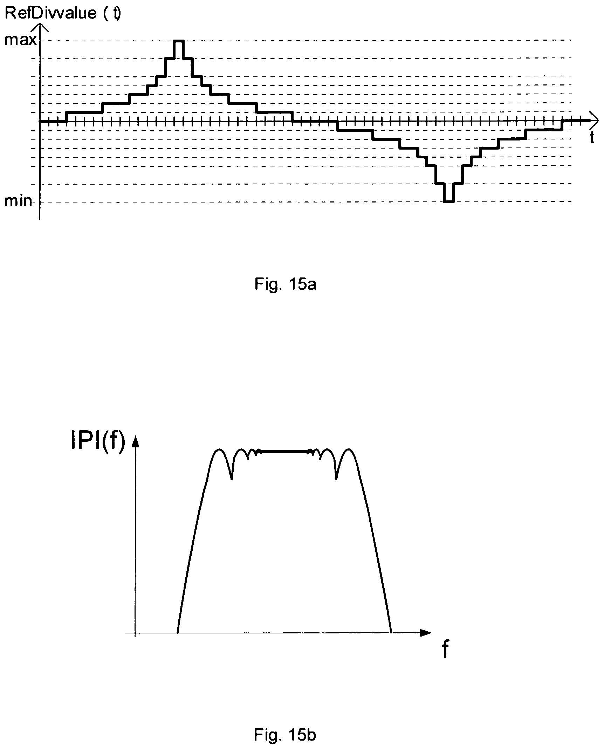

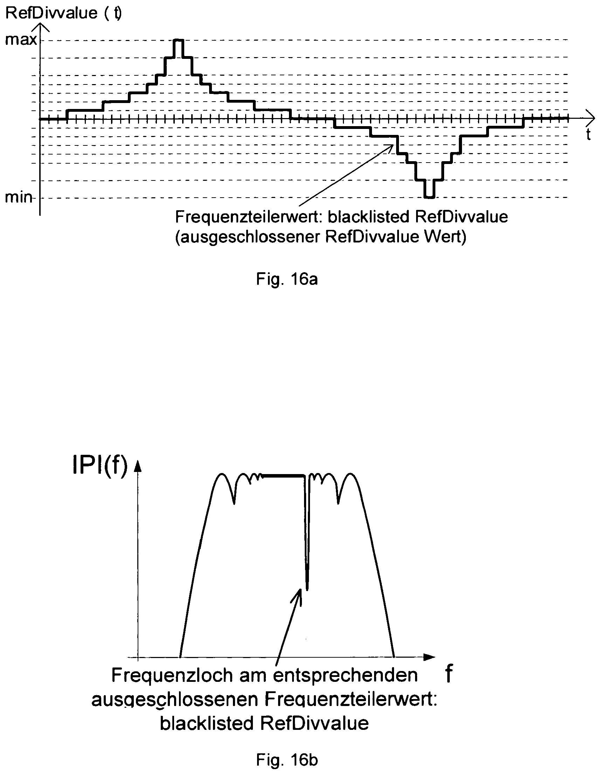

Charakteristisch für alle Ausführungsbeispiele ist, dass sich fsoll höchstens so schnell ändert wie die Einschwingzeit der PLL- Regelschlaufe ist.
Dabei generiert der Controller in einem Ausführungsbeispiel RefDivvalue Werte, welche aus einem durch minimal und maximal begrenzten Wertebereich fortlaufend zufällige Werte ausgibt. Diese Werte werden nach einer Pseudo Random Sequenz (PRS) generiert und beschreiben in mindestens einem Teilspektrum des Induktionsvektorsspektrums (gemessener Strom in einer Abstrahlungsspule) einen Sinus(x) / x.
In einem weiteren Ausführungsbeispiel generiert der Controller RefDivvalue Werte, welche aus einem durch minimal und maximal begrenzten Wertebereich eine andauernde Sweepsequenz als Werte ausgibt. Eine Sweepsequenz ist dadurch charakterisiert, dass sich die Ausgangswerte periodisch von einem minimalen Wert bis zum maximalen Wert und anschliessend vom maximalen Wert bis zum minimalen Wert usw. ändern. Figure 15a zeigt eine Periode einer solchen Sweepsequenz (RefDivvalue(t)), wobei sich die Verweilzeit (Zeitintervall, welches den gleichen RefDivvalue ausgibt) auf der Zeitachse (t) dynamisch in Abhängigkeit von RefDivvalue ändert. So gilt zum Bsp. für min und max eine Verweilzeit von einer Zeiteinheit, und andererseits für einen Mittelwert von min und max eine Verweilzeit die fünfmal länger ist. Weiter ist in einem Ausführungsbeispiel die Schrittweite der Werte RefDivvalue nicht konstant. So lässt sich wie in Figur 15a gezeigt eine kubische Funktion in RefDivvalue(t) annähern. Eine solche Funktion erzeugt ein gleichmässiges Spektrum, und zeichnet sich mit angenähert gleichem Maximalwert IPIₘₐₓ(f) aus (siehe Figur 15b).
In einem weiteren Ausführungsbeispiel werden nicht alle möglichen Refdivvalue Werte in RefDivvalue (t) ausgegeben. So wird wie in Figur 16a gezeigt, der Wert "blacklisted RefDivvalue" nicht verwendet in der Sweepsequenz. Dies hat zur Folge, dass fsoll keine Frequenz an der Stelle fref geteilt durch "blacklisted RefDivvalue" erzeugt. Daraus resultiert auch kein Spektralanteil an der entsprechenden Stelle in der VCO Frequenz. Auf diese Weise, lassen sich beliebige Einschnitte in IPIₘₐₓ(f) erzeugen (siehe Figur 16b). Es ist klar, dass sich dieses Verfahren auf jede RefDivvalue(t) Sequenz anwenden lässt, egal ob es sich um eine Sweepsequenz oder eine PRS handelt.

Der Controller in Figur 12 generiert in einem Ausführungsbeispiel pcont- und fsoll Werte, welche eine beliebige Spektralverteilung inklusive Einschnitte ergeben (z. Bsp. nach EN300330, REC7003 und ITU-RSM2123). Pcont wird dabei entweder von der Leistungsregelung zwischen Basis- und Lasteinheit bestimmt oder falls erforderlich durch maximale Werte der genannten Normen begrenzt. Vorteilhafterweise werden entsprechende RefDivvalues (min, max und ein oder mehrere blacklist RefDivvalue) als Parameter in einem Memory abgespeichert. Weiter speichert ein Memory Parameter für pcont und Parameter, welche die Verweilzeit von RefDivvalue(t) bestimmen. Der Controller kann als diskretes digitales Netzwerk, integrierte Logikschaltung (PLD, FPGA) oder als Microcontroller ausgeführt sein. Weiter ist es seit langer Zeit Stand der Technik, dass RAM / ROM Speicher (Memory) in integrierten Schaltungen mitintegriert sind (PLD, FPGAs und Microcontroller mit integriertem Speicher). Es ist weiter Stand der Technik, dass Daten Ein- / Ausgabeinterfaces (wie z. Bsp. pcont, radiationdata, coilselect und Refdivvalue) seriell oder parallel ausgeführt werden können. So kann die Controllerimplementation je nach belieben bzw. gestellten Anforderungen auch äusserst kompakt und kostengünstig realisiert werden.

Es können alle LC basierenden AC- Generatoren und alle LC-Oszillatormöglichkeiten im Zusammenhang mit gesteuerten Kapazitäten und / oder gesteuerten Induktivitäten und / oder gesteuerten Kombinationsschaltungen von beiden aufgebaut werden. Der Term "L" steht dabei für Induktivität bzw. Spule und der Term "C" steht dabei für Kapazität bzw. Kondensator.
Das einfachste Ausführungsbeispiel der aktuellen Erfindung stellt einen Wechselsspannungsgenerator mit einem abstimmbaren Resonanznetzwerk dar. In diesem Ausführungsbeispiel lässt man einfach den Feedback Block in den Figuren 3, 6 und 9 weg. Die Schalter Qv1 und Qv2 sind mit einem beliebigen externen Signal angesteuert. Die unabhängigen (vom Oszillator abgekoppelten) Ansteuersignale (V1 und V2) ergeben eine höhere Freiheit im Generatordesign. Dies kann interessant sein, falls exakte Resonanzabstimmung vernachlässigt werden kann oder die Bandbreite im Resonanzkreis sehr hoch ist.
Bei Oszillatoren spielt es für die Funktion keine Rolle, ob die Rückführung (Feedback) im Oszillator durch einen Transformator, eine induktive- oder kapazitive 3 Punktschaltung realisiert wird.
Es ist klar, dass das Verfahren gemäss der aktuellen Erfindung auch auf Vollbrückenschaltungen anwendbar ist, egal ob es sich um Ausgangsstufen oder Oszillatoren handelt.
Ein weiteres Ausführungsbeispiel der aktuellen Erfindung ist der Betrieb mehrerer VCOs gemäss der aktuellen Erfindung, welche zusammen kombiniert auf Induktionsspulen arbeiten. Da die Ströme bzw. Spannungen im Resonanzkreis alle zeitlich (Phasenlage) definiert sind in den VCOs, ist Induktionsfeldüberlagerung besonders einfach zu realisieren mittels der aktuellen Erfindung.

## Patentansprüche

1. Ein Wechselspannungs- oder Wechselstromgenerator, dessen Ausgangsnetzwerk in der Frequenz abgestimmt werden kann, wobei das Ausgangsnetzwerk ein Resonanznetzwerk enthält, dessen Resonanznetzwerk Strom- / Spannungsamplitude gesteuert wird, umfassend:
a) mindestens einen ersten Schalter (Qv1), der von einer digitalen Wechselspannung oder einem digitalen Wechselstrom angesteuert wird und dessen Last ein Resonanznetzwerk mit mindestens einer ersten Induktivität (Ltap) und mindestens einer ersten Kapazität (C0) umfasst,
b) mindestens eine zweite Induktivität (LM) oder mindestens eine zweite Kapazität (CM) oder mindestens eine Serieschaltung von einer dritten Induktivität (L01) und einer dritten Kapazität (C01), welche über mindestens einen zweiten Schalter mittels einem ON/OFF Kopplungssignal (E, E', E", F, F', F") an das Resonanznetzwerk gekoppelt ist, wobei der Lade- und Entladevorgang der zweiten Induktivität (LM) oder der zweiten Kapazität (CM) oder der Serieschaltung von der dritten Induktivität (L01) und der dritten Kapazität (C01) durch das Resonanznetzwerk erfolgt und das ON/OFF Kopplungssignal (E, E', E", F, F', F") mindestens einmal innerhalb der Resonanznetzwerkperiode wechselt und **dadurch gekennzeichnet ist,**
**dass** der mindestens eine zweite Schalter mit einer gesteuerten Verzögerung (PWM) angesteuert wird, welche von einem Vorzeichenwechsel von Strom und / oder Spannung im Resonanznetzwerk synchronisiert ist, und die Resonanznetzwerk Strom- / Spannungsamplitude des Wechselspannungs- oder Wechselstromgenerators unabhängig von der Frequenzabstimmung von einem Mittel (VCC control, DR, SMPS) gesteuert wird, welches die Betriebsspannung / den Betriebsstrom des Wechselspannungs- oder Wechselstromgenerators steuert.

2. Der Wechselspannungs- oder Wechselstromgenerator gemäss Anspruch 1, wobei die Resonanzfrequenz des Resonanznetzwerks reagierend auf eine Steuergrösse (control) in einer geschlossenen Schlaufe auf einen vorgegebenen Wert (fsoll) ausgeregelt wird.

3. Der Wechselspannungs- oder Wechselstromgenerator gemäss Anspruch 1, wobei der erste Schalter mindestens zwei Schalter (Qv1, Qv2) umfasst, welche eine Halb- oder Vollbrücke oder eine Parallelgegentaktschaltung bilden und die Resonanznetzwerk Strom- / Spannungsamplitude des Wechselspannungs- oder Wechselstromgenerators durch das Mittel (VCC control, DR, SMPS) reagierend auf ein Steuersignal (pcont) kontinuierlich ändert oder sich in der Resonanznetzwerk Strom- / Spannungsamplitude des Wechselspannungs- oder Wechselstromgenerators Burstbetrieb ergibt.

4. Der Wechselspannungs- oder Wechselstromgenerator gemäss Anspruch 1, wobei das Ansteuersignal des ersten und / oder des zweiten Schalters basierend von mindestens einem quasi Spannungs- oder Strom-Nullpunktdetektor (Q,9, Q10 bzw. Q11, Q12 bzw. QV7, QV8) generiert wird, der für die positive und negative Halbwelle den gleichen Schwellwert aufweist.

5. Ein Oszillator, dessen Strom- / Spannungsamplitude und dessen Frequenz gesteuert werden umfassend:
a) mindestens eine erste Induktivität (Ltap) und mindestens eine erste Kapazität (C0) die miteinander gekoppelt sind und mindestens einen Teil eines Resonanznetzwerkes bilden,
b) mindestens eine zweite Induktivität (LM) oder mindestens eine zweite Kapazität (CM) oder mindestens eine Serieschaltung von einer dritten Induktivität (L01) und einer dritten Kapazität (C01),
c) mindestens einen zweiten Schalter, gesteuert von einem ON/OFF Kopplungssignal (E, E', E", F, F', F"), um die zweite Induktivität (LM) oder die zweite Kapazität (CM) oder die Serieschaltung von der dritten Induktivität (L01) und der dritten Kapazität (C01) über eine gesteuerte Verzögerung (PWM) an das Resonanznetzwerk zu koppeln, wobei der Lade- und Entladevorgang der zweiten Induktivität (LM) oder der zweiten Kapazität (CM) oder der Serieschaltung von der dritten Induktivität (L01) und der dritten Kapazität (C01) durch das Resonanznetzwerk erfolgt und das ON/OFF Kopplungssignal (E, E', E", F, F', F") mindestens einmal innerhalb der Resonanznetzwerkperiode wechselt, und
d) mindestens einen ersten Schalter (Qv1) der **dadurch gekennzeichnet ist,**
**dass** der mindestens eine erste Schalter (Qv1) digital gesteuert wird und so mit dem Resonanznetzwerk gekoppelt ist, dass der erste Schalter und das Resonanznetzwerk als Oszillator operieren und die Oszillator Strom- / Spannungsamplitude unabhängig von der Frequenzsteuerung von einem Mittel (VCC control, SMPS) gesteuert wird, welches die Betriebsspannung / den Betriebsstrom des Oszillators steuert.

6. Der Oszillator gemäss Anspruch 5, wobei die Resonanzfrequenz des Resonanznetzwerks reagierend auf eine Steuergrösse (control) in einer geschlossenen Schlaufe auf einen vorgegebenen Wert (fsoll) ausgeregelt wird.

7. Der Oszillator gemäss Anspruch 5, wobei der erste Schalter mindestens zwei Schalter (Qv1, Qv2) umfasst, welche eine Halb- oder Vollbrücke oder eine Parallelgegentaktschaltung bilden und die Resonanznetzwerk Strom- / Spannungsamplitude des Oszillators durch das Mittel (VCC control, DR, SMPS) reagierend auf ein Steuersignal (pcont) kontinuierlich ändert oder sich in der Resonanznetzwerk Strom- / Spannungsamplitude des Oszillators Burstbetrieb ergibt.

8. Der Oszillator gemäss Anspruch 5, wobei das Ansteuersignal des ersten und/oder des zweiten Schalters basierend von mindestens einem quasi Spannungs- oder Strom- Nullpunktdetektor (Q,9, Q10 bzw. Q11, Q12 bzw. QV7, QV8) generiert wird, der für die positive und negative Halbwelle den gleichen Schwellwert aufweist.

9. Der Oszillator gemäss Anspruch 5, wobei der erste Schalter mindestens zwei Schalter (Qv1, Qv2) umfasst und mindestens ein Spannungsdetektor (QV7) die Oszillatorrückführung symmetrisch am Resonanznetzwerk abgreift.

10. Ein Oszillator, dessen Strom- / Spannungsamplitude und dessen Frequenz gesteuert wird umfassend:
a) mindestens eine erste Induktivität (Ltap) und mindestens eine erste Kapazität (C0) die miteinander gekoppelt sind und mindestens einen Teil eines Resonanznetzwerkes bilden,
b) mindestens eine zweite Induktivität (LM) oder mindestens eine zweite Kapazität (CM) oder mindestens eine Serieschaltung von einer dritten Induktivität (L01) und einer dritten Kapazität (C01),
c) mindestens einen zweiten Schalter, gesteuert von einem ON/OFF Kopplungssignal (E, E', E", F, F', F"), um die zweite Induktivität (LM) oder die zweite Kapazität (CM) oder die Serieschaltung von der dritten Induktivität (L01) und der dritten Kapazität (C01) über eine gesteuerte Verzögerung (PWM) an das Resonanznetzwerk zu koppeln, wobei der Lade- und Entladevorgang der zweiten Induktivität (LM) oder der zweiten Kapazität (CM) oder der Serieschaltung von der dritten Induktivität (L01) und der dritten Kapazität (C01) durch das Resonanznetzwerk erfolgt und das ON/OFF Kopplungssignal (E, E', E", F, F', F") mindestens einmal innerhalb der Resonanznetzwerkperiode wechselt, und
d) mindestens einen ersten Schalter (Qv1) der **dadurch gekennzeichnet ist,**
**dass** der erste Schalter (Qv1) digital gesteuert wird und so mit dem Resonanznetzwerk gekoppelt ist, dass der erste Schalter und das Resonanznetzwerk als Oszillator operieren und das Ansteuersignal des ersten und/oder des zweiten Schalters basierend mindestens einem quasi Spannungs- oder Strom- Nullpunktdetektor (Q,9, Q10 bzw. Q11, Q12 bzw. QV7, QV8) generiert wird, der für die positive und negative Halbwelle den gleichen Schwellwert aufweist und die Oszillator Strom- / Spannungsamplitude von einem Mittel (VCC control, SMPS) gesteuert wird, welches die Betriebsspannung / den Betriebsstrom des Oszillators steuert.

11. Der Oszillator gemäss Anspruch 10, wobei die Resonanzfrequenz des Resonanznetzwerks reagierend auf eine Steuergrösse (control) in einer geschlossenen Schlaufe auf einen vorgegebenen Wert (fsoll) ausgeregelt wird und die Oszillator Strom- / Spannungsamplitude unabhängig von der Frequenzsteuerung vom Mittel (VCC control, SMPS) gesteuert wird.

12. Der Oszillator gemäss Anspruch 10, wobei der erste Schalter mindestens zwei Schalter (Qv1, Qv2) umfasst, welche eine Halb- oder Vollbrücke oder eine Parallelgegentaktschaltung bilden und die Resonanznetzwerk Strom- / Spannungsamplitude des Oszillators durch das Mittel (VCC control, DR, SMPS) reagierend auf ein Steuersignal (pcont) kontinuierlich ändert oder sich in der Resonanznetzwerk Strom- / Spannungsamplitude des Oszillators Burstbetrieb ergibt.

13. Der Oszillator gemäss Anspruch 10, wobei der erste Schalter mindestens zwei Schalter (Qv1, Qv2) umfasst und mindestens ein Spannungsdetektor (QV7) die Oszillatorrückführung symmetrisch am Resonanznetzwerk abgreift.

## Claims

1. An alternating voltage- or alternating current generator whose output network can be tuned in frequency, the output network including a resonant network whose resonant network current- / voltage amplitude is controlled comprising:
a) at least one first switch (Qv1) which is driven by a digital alternating voltage or a digital alternating current and whose load comprises a resonant network having at least one first inductance (Ltap) and at least one first capacitance (C0),
b) at least one second inductance (LM) or at least one second capacitance (CM) or at least one series circuit of a third inductance (L01) and a third capacitance (C01) which is coupled to the resonant network via at least one second switch by means of an ON/OFF coupling signal (E, E', E", F, F', F"), wherein the second inductance (LM) or the second capacitance (CM) or the series circuit of the third inductance (L01) and the third capacitance (C01) is charged and discharged by the resonant network and the ON/OFF coupling signal (E, E', E", F, F', F") changes at least once within the resonant network period and is **characterized in that**
the at least one second switch is driven with a controlled delay (PWM) which is synchronized by a sign change of current and / or voltage in the resonant network, and the resonant network current / voltage amplitude of the alternating voltage or alternating current generator is controlled independently of the frequency tuning by a means (VCC control, DR, SMPS) which controls the operating voltage / the operating current of the alternating voltage or alternating current generator.

2. The alternating voltage or alternating current generator according to claim 1, wherein the resonance frequency of the resonant network is regulated to a predetermined value (fsoll) responsive to a control variable (control) in a closed loop.

3. The alternating voltage or alternating current generator according to claim 1, wherein the first switch comprises at least two switches (Qv1, Qv2) which form a half- or full bridge or a parallel push-pull circuit, and the resonant network current- / voltage amplitude of the alternating voltage or alternating current generator changes continuously or establishes Burst Mode by the means (VCC control, DR, SMPS) responsive to a control signal (pcont).

4. The alternating voltage or alternating current generator according to claim 1, wherein the drive signal of the first and / or second switch is generated based on at least one quasi zero voltage- or current detector (Q,9, Q10 or Q11, Q12 or QV7, QV8) having the same threshold value for the positive and negative half-wave.

5. An oscillator whose current- / voltage amplitude and frequency are controlled comprising:
a) at least one first inductance (Ltap) and at least one first capacitance (C0) coupled together and forming at least a part of a resonant network,
b) at least one second inductance (LM) or at least one second capacitance (CM) or at least one series circuit of a third inductance (L01) and a third capacitance (C01),
c) at least one second switch controlled by an ON/OFF coupling signal (E, E', E", F, F', F") for coupling the second inductance (LM) or the second capacitance (CM) or the series connection of the third inductance (L01) and the third capacitance (C01) to the resonant network via a controlled delay (PWM), wherein the charging and discharging of the second inductance (LM) or the second capacitance (CM) or the series circuit of the third inductance (L01) and the third capacitance (C01) is performed by the resonant network, and the ON/OFF coupling signal (E, E', E", F, F', F") changes at least once within the resonant network period, and
d) at least one first switch (Qv1) **characterized in that**
the at least one first switch (Qv1) is controlled digitally and is coupled to the resonant network in such a way that the first switch and the resonant network operate as an oscillator and the oscillator current- / voltage amplitude is controlled independently of the frequency control by a means (VCC control, SMPS) which controls the operating voltage / current of the oscillator.

6. The oscillator according to claim 5, wherein the resonance frequency of the resonant network is adjusted to a predetermined value (fsoll) responsive to a control variable (control) in a closed loop.

7. The oscillator according to claim 5, wherein the first switch comprises at least two switches (Qv1, Qv2) which form a half- or full bridge or a parallel push-pull circuit and the resonance network current / voltage amplitude of the oscillator changes continuously or establishes Burst Mode by the means (VCC control, DR, SMPS) responsive to a control signal (pcont).

8. The oscillator according to claim 5, wherein the drive signal of the first and/or second switch is generated based on at least one quasi voltage- or current detector (Q,9, Q10 or Q11, Q12 or QV7, QV8) having the same threshold value for the positive and negative half-wave.

9. The oscillator according to claim 5, wherein the first switch comprises at least two switches (Qv1, Qv2) and at least one voltage detector (QV7) taps the oscillator feedback at the resonance network symmetrically.

10. An oscillator whose current- / voltage amplitude and frequency is controlled comprising:
a) at least one first inductance (Ltap) and at least one first capacitance (C0) which are coupled to one another and form at least a part of a resonance network,
b) at least one second inductance (LM) or at least one second capacitance (CM) or at least one series circuit of a third inductance (L01) and a third capacitance (C01),
c) at least one second switch controlled by an ON/OFF coupling signal (E, E', E", F, F', F") for coupling the second inductance (LM) or the second capacitance (CM) or the series connection of the third inductance (L01) and the third capacitance (C01) to the resonant network via a controlled delay (PWM), wherein the charging and discharging of the second inductance (LM) or the second capacitance (CM) or the series circuit of the third inductance (L01) and the third capacitance (C01) is performed by the resonant network, and the ON/OFF coupling signal (E, E', E", F, F', F") changes at least once within the resonant network period, and
d) at least one first switch (Qv1) **characterized in that**
the first switch (Qv1) is digitally controlled and coupled to the resonant network in such a way that the first switch and the resonant network operate as an oscillator and the drive signal of the first and / or second switch is generated based on at least one quasi zero voltage- or current detector (Q,9, Q10 or Q11, Q12 or QV7, QV8) for detecting the positive and negative half-waves with the same threshold level and the oscillator current- / voltage amplitude is controlled by a means (VCC control, SMPS) which controls the operating voltage / current of the oscillator.

11. The oscillator according to claim 10, wherein the resonance frequency of the resonant network is adjusted to a predetermined value (fsoll) responsive to a control variable (control) in a closed loop and the oscillator current- / voltage amplitude is controlled independently of the frequency control by the means (VCC control, SMPS).

12. The oscillator according to claim 10, wherein the first switch comprises at least two switches (Qv1, Qv2) which form a half- or full bridge or a parallel push-pull circuit and the resonance network current- / voltage amplitude of the oscillator changes continuously or establishes Burst Mode by the means (VCC control, DR, SMPS) responsive to a control signal (pcont).

13. The oscillator according to claim 10, wherein the first switch comprises at least two switches (Qv1, Qv2) and at least one voltage detector (QV7) taps the oscillator feedback at the resonance network symmetrically.

## Revendications

1. Un générateur de tension alternative ou de courant alternatif dont le réseau de sortie peut être ajusté en fréquence, le réseau de sortie comprenant un réseau résonnant dont l'amplitude du courant / de la tension du réseau résonnant est contrôlée, comprenant:
a) au moins un premier commutateur (Qv1) qui est commandé par une tension alternative numérique ou un courant alternatif numérique et dont la charge comprend un réseau résonnant ayant au moins une première inductance (Ltap) et au moins une première capacité (C0),
b) au moins une deuxième inductance (LM) ou au moins une deuxième capacité (CM) ou au moins un circuit série d'une troisième inductance (L01) et d'une troisième capacité (C01) qui est couplé au réseau résonnant par au moins un deuxième commutateur au moyen d'un signal de couplage ON/OFF (E, E', E", F, F', F"), dans laquelle la deuxième inductance (LM) ou la deuxième capacité (CM) ou le circuit série de la troisième inductance (L01) et de la troisième capacité (C01) est chargé et déchargé par le réseau résonnant et le signal de couplage ON/OFF (E, E', E", F, F', F") change au moins une fois pendant la période du réseau résonnant et est **caractérisé en ce que**
l'au moins un deuxième commutateur est commandé avec un retard controllé (PWM) qui est synchronisé par un changement de signe du courant et/ou de la tension dans le réseau résonnant, et l'amplitude du courant / de la tension du réseau résonnant de la tension alternative ou du générateur de courant alternatif est commandée indépendamment du réglage de la fréquence par un moyen (commande VCC, DR, SMPS) qui commande la tension de fonctionnement / le courant de fonctionnement du générateur de tension alternative ou de courant alternatif.

2. Le générateur de tension alternative ou de courant alternatif selon la revendication 1, dans lequel la fréquence de résonance du réseau résonnant est régulée à une valeur prédéterminée (fsoll) dépendante d'une variable de contrôle (control) dans une boucle fermée.

3. Le générateur de tension alternative ou de courant alternatif selon la revendication 1, dans lequel le premier commutateur comprend au moins deux commutateurs (Qv1, Qv2) qui forment un demi pont ou un pont complet ou un circuit push-pull parallèle, et l'amplitude du courant / tension du réseau résonnant du générateur de tension alternative ou de courant alternatif change continuellement ou établit le mode rafale par le moyen (control, VCC, DR, SMPS) déendante d'un signal de commande (pcont).

4. Générateur de tension alternative ou de courant alternatif selon la revendication 1, dans lequel le signal de commande du premier et/ou du second commutateur est généré sur la base d'au moins un détecteur de tension ou de courant quasi nul (Q, 9, Q10 ou Q11, Q12 ou QV7, QV8) ayant la même valeur seuil pour la demi-onde positive et négative.

5. Oscillateur dont l'amplitude et la fréquence courant / tension sont contrôlées comprenant:
a) au moins une première inductance (Ltap) et au moins une première capacité (C0) couplées ensemble et formant au moins une partie d'un réseau résonant,
b) au moins une deuxième inductance (LM) ou au moins une deuxième capacité (CM) ou au moins un circuit série d'une troisième inductance (L01) et une troisième capacité (C01),
c) au moins un second commutateur commandé par un signal de couplage ON/OFF (E, E', E", F, F', F") pour coupler la seconde inductance (LM) ou la seconde capacité (CM) ou la connexion en série de la troisième inductance (L01) et la troisième capacité (C01) au réseau résonant via un retard contrôlé (PWM), dans lequel la charge et la décharge de la deuxième inductance (LM) ou de la deuxième capacité (CM) ou du circuit série de la troisième inductance (L01) et de la troisième capacité (C01) sont effectuées par le réseau résonnant, et le signal de couplage ON/OFF (E, E', E", F, F', F") change au moins une fois pendant la période du réseau résonnant, et
d) au moins un premier commutateur (Qv1) **caractérisé en ce que**
le au moins un premier commutateur (Qv1) est commandé numériquement et est couplé au réseau résonnant de telle sorte que le premier commutateur et le réseau résonnant fonctionnent comme oscillateur et que l'amplitude du courant / tension de l'oscillateur est commandée indépendamment de la commande de fréquence par un moyen (control, VCC, SMPS) qui commande la tension / le courant de fonctionnement de l'oscillateur.

6. Oscillateur selon la revendication 5, dans lequel la fréquence de résonance du réseau résonnant est ajustée à une valeur prédéterminée (fsoll) dépendante d'une grandeur de commande (control) dans une boucle fermée.

7. Oscillateur selon la revendication 5, dans lequel le premier commutateur comprend au moins deux commutateurs (Qv1, Qv2) qui forment un demi pont partiel ou un pont complet ou un circuit push-pull parallèle et l'amplitude du courant / tension du réseau de résonance de l'oscillateur change continuellement ou établit le mode rafale par les moyens (control, VCC, DR, SMPS) en fonctiond' un signal de commande (pcont).

8. Oscillateur selon la revendication 5, dans lequel le signal de commande du premier et/ou du second commutateur est généré sur la base d'au moins un détecteur de tension ou de courant (Q, 9, Q10 ou Q11, Q12 ou QV7, QV8) ayant la même valeur seuil pour la demi-onde positive et négative.

9. Oscillateur selon la revendication 5, le premier commutateur comprenant au moins deux commutateurs (Qv1, Qv2) et au moins un détecteur de tension (QV7) qui exploite symétriquement la rétroaction de l'oscillateur sur le réseau de résonance.

10. Oscillateur dont l'amplitude et la fréquence courant / tension sont contrôlées, comprenant :
a) au moins une première inductance (Ltap) et au moins une première capacité (C0) qui sont couplées l'une à l'autre et forment au moins une partie d'un réseau résonant,
b) au moins une deuxième inductance (LM) ou au moins une deuxième capacité (CM) ou au moins un circuit série d'une troisième inductance (L01) et une troisième capacité (C01),
c) au moins un second commutateur commandé par un signal de couplage ON/OFF (E, E', E", F, F', F") pour coupler la seconde inductance (LM) ou la seconde capacité (CM) ou la connexion en série de la troisième inductance (L01) et la troisième capacité (C01) au réseau résonant via un retard contrôlé (PWM), dans laquelle la charge et la décharge de la deuxième inductance (LM) ou de la deuxième capacité (CM) ou du circuit série de la troisième inductance (L01) et de la troisième capacité (C01) sont effectuées par le réseau résonnant, et le signal de couplage ON/OFF (E, E', E", F, F', F") change au moins une fois pendant la période du réseau résonnant, et
d) au moins un premier commutateur (Qv1) **caractérisé en ce que**
le premier commutateur (Qv1) est commandé numériquement et couplé au réseau résonnant de telle sorte que le premier commutateur et le réseau résonnant fonctionnent comme oscillateur et que le signal de commande du premier et/ou du second commutateur est généré sur la base d'au moins un détecteur de tension ou de courant quasi nul (Q,9, Q10 ou Q11, Q12 ou QV7, QV8) pour la détection des demi-ondes positives et négatives avec le même niveau de seuil et l'amplitude courant / tension de l'oscillateur est commandée par un moyen (control, VCC, SMPS) qui commande la tension / courant de fonctionnement de l'oscillateur.

11. Oscillateur selon la revendication 10, dans lequel la fréquence de résonance du réseau résonnant est ajustée à une valeur prédéterminée (fsoll) dépendante d'une grandeur de commande (control) dans une boucle fermée et l'amplitude courant / tension de l'oscillateur est commandée indépendamment de la commande de fréquence par les moyens (control, VCC, SMPS).

12. Oscillateur selon la revendication 10, dans lequel le premier commutateur comprend au moins deux commutateurs (Qv1, Qv2) qui forment un demi-pont ou un pont complet ou un circuit push-pull parallèle et l'amplitude du courant / tension du réseau de résonance de l'oscillateur change continuellement ou établit un mode rafale par le moyen (commande VCC, DR, SMPS) dépendant d'un signal de commande (pcont).

13. Oscillateur selon la revendication 10, le premier commutateur comprenant au moins deux commutateurs (Qv1, Qv2) et au moins un détecteur de tension (QV7) qui exploite symétriquement la rétroaction de l'oscillateur sur le réseau résonnant.
